# EUROPÄISCHE PATENTSCHRIFT

(11) **EP 1 704 759 B1**
(45) Veröffentlichungstag und Bekanntmachung des Hinweises auf die Patenterteilung: **28.03.2007**
(21) Anmeldenummer: 05700882.3
(22) Anmeldetag: 13.01.2005
(51) Int. Cl.: H05K 3/00

(54) **DÜSENANORDNUNG UND VERFAHREN ZUR BEHANDLUNG EINES BEHANDLUNGSGUTES MIT EINEM BEHANDLUNGSMEDIUM**
NOZZLE ARRANGEMENT AND METHOD FOR PROCESSING A MATERIAL FOR PROCESSING WITH A PROCESSING MEDIUM
DISPOSITIF INJECTEUR ET PROCEDE DE TRAITEMENT D'UN PRODUIT AU MOYEN D'UN MILIEU DE TRAITEMENT

(30) Priorität: 16.01.2004 DE 102004002421
(43) Veröffentlichungstag der Anmeldung: 27.09.2006
(73) Patentinhaber: ATOTECH Deutschland GmbH, 10553 Berlin (DE)
(72) Erfinder: KUNZE, Henry, 90530 Wendelstein (DE); WIENER, Ferdinand, 90559 Burgthann (DE)
(74) Vertreter: Banzer, Hans-Jörg
(86) Internationale Anmeldenummer: PCT/EP2005/000269
(87) Internationale Veröffentlichungsnummer: WO 2005/069704

(56) Entgegenhaltungen:
- EP-A- 1 083 245
- WO-A-98/31475
- JP-A- 3 050 792
- US-A- 2 900 992
- "SPRAY NOZZLE CONFIGURATION FOR MAXIMIZING DEVELOP/ETCH RATE AND UNIFORMITY" IBM TECHNICAL DISCLOSURE BULLETIN, IBM CORP. NEW YORK, US, Bd. 38, Nr. 4, 1. April 1995 (1995-04-01), Seiten 403-405, XP000516195 ISSN: 0018-8689

## Beschreibung

Die vorliegende Erfindung betrifft eine Düsenanordnung und ein Verfahren zur Behandlung eines Behandlungsgutes mit einem Behandlungsmedium. Insbesondere betrifft die vorliegende Erfindung eine Schwalldüsenanordnung, welche beispielsweise in Durchlaufanlagen zum nasschemischen Behandeln von dünnsten Leiterfolien bzw. Leiterplatten eingesetzt werden kann.

Düsenanordnungen in Form von Schwalldüsen werden beispielsweise in Durchlaufanlagen zur nasschemischen Behandlung von Leiterplatten eingesetzt, um eine möglichst schnelle und gleichmäßige Behandlung eines Behandlungsgutes in Form von durchlaufenden Leiterplatten oder Leiterfolien zu erzielen. Dabei werden üblicherweise mehrere Schwalldüsen oberhalb und/oder unterhalb einer Durchlaufebene des Behandlungsgutes angeordnet, so dass sich die Düsenanordnung quer zu einer Transportrichtung des Behandlungsgutes im Wesentlichen über dessen gesamte Breite erstreckt. Mit den Schwalldüsen wird eine Behandlungsflüssigkeit auf die Oberfläche des Behandlungsgutes gestrahlt oder von dieser abgesaugt, um dadurch einen ständigen und gleichmäßigen Austausch der Behandlungsflüssigkeit an der Oberfläche des Behandlungsgutes zu erzielen: (siehe z.B. US-A-2 900 992 und EP-A-1 083 245).

In der EP 1 187 515 A2 wird diesbezüglich eine Vielzahl unterschiedlicher Düsenanordnungen vorgeschlagen. Dabei kommen jeweils im Wesentlichen runde Rohre zum Einsatz, welche unterschiedliche Düsenformen aufweisen. Bei diesen Düsenformen kann es sich beispielsweise um schräg angeordnete Schlitzdüsen, in einer Vielzahl von Reihen nebeneinander angeordnete Runddüsen oder aber auch um in Reihen nebeneinander verlaufende Schlitzdüsen mit unterschiedlicher Breite handeln. Bei den beschriebenen Düsenanordnungen handelt es sich insbesondere um Schwenkdüsen, mit welchen eine periodische Änderung der Richtung eines Flüssigkeitsstrahls der Behandlungsflüssigkeit während des Vorbeilaufs des Behandlungsgutes erzielt wird.

In der DE 37 08 529 A1 wird der Einsatz von Schlitzdüsen vorgeschlagen, wobei durch eine variable Schlitzbreite der entsprechenden Düse die Durchflussmenge und ein Sprühdruck der jeweiligen Behandlungsflüssigkeit eingestellt werden kann.

In der DE 35 28 575 A1 wird zum Reinigen, Aktivieren und/oder Metallisieren von Bohrlöchern in horizontal durchlaufenden Leiterplatten eine unterhalb der Transportebene und senkrecht zur Transportrichtung angeordnete Düse verwendet, aus welcher ein flüssiges Behandlungsmittel in Form einer stehenden Welle an die Unterseite der jeweils durchlaufenden Leiterplatte gefördert wird. Die Düse ist im oberen Teil eines Düsengehäuses angeordnet, welches aus einer Vorkammer mit einem Einlaufstutzen gebildet ist, wobei die Vorkammer mittels einer Lochmaske von einem oberen Teil eines Innenraums der Düse abgetrennt ist. Durch die Lochmaske wird eine Verteilung der Strömung des flüssigen Behandlungsmittels zur Düse hin erzielt. Der Innenraum der Düse vor einer eigentlichen Düsenöffnung in Form eines Schlitzes dient als Vorkammer für eine gleichmäßige Ausbildung des Schwalls des flüssigen Behandlungsmittels.

Aus der EP 0 280 078 B1 ist eine Düsenanordnung zur Reinigung oder chemischen Behandlung von Werkstücken, insbesondere Leiterplatten, mittels einer entsprechenden Behandlungsflüssigkeit bekannt. Die Düsenanordnung umfasst einen unteren Zulaufkasten und einen Gehäusekasten, wobei durch den unteren Zulaufkasten die Behandlungsflüssigkeit durch im Boden des Gehäusekastens befindliche Bohrungen in das Innere des Gehäusekastens geführt-wird. Der Gehäusekasten weist eine mittlere Trennwand in Kombination mit zwei Perforationsebenen und darüber angeordneten Schlitzen auf, wodurch erreicht wird, dass die Behandlungsflüssigkeit zu den beiden Schlitzen fließt und sich darüber zwei gleichmäßige sinusförmige Schwallwellenprofile ausbilden, welche die Werkstücke, insbesondere die Bohrlöcher von Leiterplatten, durchströmen. Ein intensiver Stoffaustausch ist dabei durch den Venturi-Effekt gewährleistet.

Bei den oben beschriebenen Schwalldüsenanordnungen ist die Strömungsgeschwindigkeit in einem Anschlussbereich zur Zuführung der Behandlungsflüssigkeit am größten, da hier die größte Menge an Behandlungsflüssigkeit durchtritt. Mit zunehmender Entfernung von dem Anschlussbereich nimmt die Strömungsgeschwindigkeit entsprechend ab, da über einzelne Düsenöffnungen der Schwalldüsenanordnungen jeweils ein Teil der Behandlungsflüssigkeit abfließt. Dadurch kommt es neben einem statischen Druck auch zu einem Staudruck und ungleichmäßigen Strömungsgeschwindigkeiten an den Düsenöffnungen. Eine weitere Folge sind unterschiedlich große Austrittsmengen an Behandlungsflüssigkeit.

Bei der nasschemischen Behandlung von sehr dünnem und/oder empfindlichem Behandlungsgut besteht zudem die Gefahr, dass das Behandlungsgut von dem auf eine Kante des Behandlungsgutes auftreffenden Flüssigkeitsschwall in einem Einlaufbereich der Düsenanordnung aus der Transportbahn gelenkt wird. Dies kann dazu führen, dass das Behandlungsgut an der Düsenanordnung entlang kratzt oder vollständig hängen bleibt, was zu Ausschuss an Behandlungsgut bzw. zu einem Stau innerhalb einer entsprechenden Behandlungsanlage führt. Im Falle eines Staus muss die Produktion unterbrochen werden, um den Stau zu beseitigen, was meist zu weiterem Ausschuss wegen zu langer Behandlungszeit in anderen Behandlungsstationen führt.

Der vorliegenden Erfindung liegt daher die Aufgabe zugrunde, eine Düsenanordnung bwz. ein Verfahren zur Behandlung eines Behandlungsgutes, insbesondere zur Behandlung von dünnstem plattenförmigem Behandlungsgut mit einer Behandlungsflüssigkeit, bereitzustellen, welche das oben genannte Problem löst und insbesondere vermeidet, dass das Behandlungsgut durch die Strömung der Behandlungsflüssigkeit oder eines anderen Behandlungsmediums in einem Einlaufbereich der Düsenanordnung aus der Transportbahn gelenkt wird. Dies bedeutet, das in dem Einlaufbereich der Düsenanordnung die Kräfte senkrecht zur Ebene des Behandlungsgutes möglichst gering sein müssen.

Erfindungsgemäß wird diese Aufgabe durch eine Düsenanordnung mit den Merkmalen des unabhängigen Anspruches 1, durch eine Vorrichtung mit den Merkmalen des Anspruches 30 und durch ein Verfahren mit den Merkmalen des unabhängigen Anspruches 31 gelöst. Die abhängigen Ansprüche definieren jeweils bevorzugte oder vorteilhafte Ausführungsformen der Erfindung.

Die grundsätzliche Idee, auf welcher das erfindungsgemäße Verfahren und die erfindungsgemäße Düsenanordnung beruhen, besteht darin, dass eine Abgabe bzw. Aufnahme eines Behandlungsmediums mit einer Strömungskomponente in einer Transportrichtung eines Behandlungsgutes erfolgt. Hierdurch wird das Behandlungsmedium in der Umgebung eines Einlaufbereichs der Düsenanordnung bzw. eines Behandlungskanals angesaugt, so dass der Transport des Behandlungsgutes in den Behandlungskanal unterstützt wird.

Die erfindungsgemäße Düsenanordnung dient zur Behandlung von Behandlungsgut, z.B. in Form von Leiterplatten oder Leiterfolien, als Platten oder Endlosmaterial, mit einer Behandlungsflüssigkeit oder allgemeiner einem Behandlungsmedium, wobei das Behandlungsgut in einer Transportebene entlang der Transportrichtung von einem Einlaufbereich zu einem Auslaufbereich der Düsenanordnung transportierbar ist. Bei dem Behandlungsmedium kann es sich neben einer Behandlungsflüssigkeit z.B. auch um ein gasförmiges Behandlungsmedium handeln Die Düsenanordnung umfasst dabei mindestens eine Düsenöffnung, welche derart ausgestaltet ist, dass ein Flüssigkeitsstrom der Behandlungsflüssigkeit bzw. Strom des Behandlungsmediums durch die Düsenöffnung in einem vorgegebenen Winkel schräg bezüglich der Transportebene des Behandlungsgutes verläuft. Der Winkel ist derart vorgegeben, dass der Flüssigkeitsstrom oder Strom des Behandlungsmediums in die Transportrichtung des Behandlungsgutes gelenkt wird bzw. aus der Düsenöffnung bereits in dieser Richtung ausströmt.

Hierdurch wird erreicht, dass die Behandlungsflüssigkeit oder Behandlungsmedium im Wesentlichen von der mindestens einen Düsenöffnung in Richtung des Auslaufbereichs der Düsenanordnung, nicht jedoch in Richtung des Einlaufbereichs der Düsenanordnung, strömt. Hierdurch entsteht ein Unterdruck in einem von der Düsenanordnung und dem Behandlungsgut gebildeten Behandlungskanal der Düsenanordnung, durch welchen umgebendes Behandlungsmedium im Einlaufbereich der Düsenanordnung angesaugt wird und verhindert wird, dass das Behandlungsgut aus der Transportebene bzw. einer vorgesehenen Transportbahn gelenkt wird.

Die Lenkung des Flüssigkeitsstroms oder Stroms des Behandlungsmediums erfolgt vorzugsweise dadurch, dass die mindestens eine Düsenöffnung durch mindestens einen Düsenöffnungskanal gebildet ist, welcher in einem spitzen Winkel bezüglich der Transportebene des Behandlungsgutes verläuft. Der Winkel beträgt dabei bevorzugt höchstens 80°. Als besonders vorteilhaft hat sich jedoch ein Winkel zwischen 0° und 60° bzw. noch bevorzugter 10° und 30° erwiesen.

Die erfindungsgemäße Düsenanordnung kann entweder zum Strahlen des Behandlungsmediums auf das Behandlungsgut oder zum Absaugen des Behandlungsmediums ausgestaltet sein. In dem ersten Fall, d.h. wenn die mindestens eine Düsenöffnung zur Abgabe des Behandlungsmediums ausgestaltet ist, öffnet sich der Winkel entgegen der Transportrichtung des Behandlungsgutes, so dass der Strom des Behandlungsmediums in die Transportrichtung des Behandlungsgutes gelenkt wird. In diesem Fall ist es besonders vorteilhaft, wenn die mindestens eine Düsenöffnung in einer im Wesentlichen entlang der Transportebene verlaufenden Gehäusewand der Düsenanordnung derart angeordnet ist, dass ein Abstand der mindestens einen Düsenöffnung zu dem Einlaufbereich kleiner ist als ein Abstand der mindestens einen Düsenöffnung zu dem Auslaufbereich.

In dem zweiten Fall, d.h. wenn die mindestens eine Düsenöffnung zur Aufnahme bzw. zum Absaugen des Behandlungsmediums ausgestaltet ist, öffnet der Winkel sich in Transportrichtung des Behandlungsgutes, so dass wiederum erreicht wird, dass der Strom des Behandlungsmediums in die Transportrichtung des Behandlungsgutes gelenkt wird. In diesem Fall ist es besonders vorteilhaft, dass die mindestens eine Düsenöffnung in der im Wesentlichen entlang der Transportebene verlaufenden Gehäusewand derart angeordnet ist, dass ein Abstand der mindestens einen Düsenöffnung zu dem Auslaufbereich kleiner ist als ein Abstand der mindestens einen Düsenöffnung zu dem Einlaufbereich.

Durch diese asymmetrische Ausgestaltung der Düsenanordnung wird gewährleistet, dass sich ein verlängerter Behandlungskanal zwischen der Düsenanordnung und dem Behandlungsgut ausbildet, in welchem das Behandlungsmedium in der Transportrichtung des Behandlungsgutes strömt. Hierdurch wird eine effektivere Behandlung des Behandlungsgutes mit dem Behandlungsmedium gewährleistet. Es ist jedoch nicht zwingend erforderlich, dass die Düsenöffnung in der Nähe des Einlaufbereichs oder des Auslaufbereichs angeordnet ist.

Vorzugsweise ist die Düsenanordnung derart ausgestaltet, dass sich ein Abstand einer Gehäusewand der Düsenanordnung, vorzugsweise derjenigen Gehäusewand, in welcher die mindestens eine Düsenöffnung angeordnet ist, sich zu der Transportebene in einem Abschnitt zwischen dem Einlaufbereich und der mindestens einen Düsenöffnung in der Transportrichtung des Behandlungsgutes verringert. Hierdurch wird in diesem Abschnitt ein sich in Richtung des Einlaufbereichs keilförmig öffnender Kanal zwischen der Gehäusewand und der Transportebene gebildet. Vorzugsweise ist die Düsenanordnung auch derart ausgestaltet, dass sich ein Abstand der Gehäusewand der Düsenanordnung zu der Transportebene in einem Abschnitt zwischen der mindestens einen Düsenöffnung und dem Auslaufbereich in der Transportrichtung des Behandlungsgutes vergrößert, so dass in diesem Abschnitt ein sich in Richtung des Auslaufbereichs keilförmig öffnender Kanal zwischen der Gehäusewand und der Transportebene gebildet wird.

Die keilförmigen Kanäle, welche vorzugsweise beidseitig des Behandlungsgutes ausgebildet sind, insbesondere die Kombination der oben genannten keilförmigen Kanäle, erzeugen durch den so genannten Venturi-Effekt einen zusätzlichen Unterdruck in dem Einlaufbereich der Düsenanordnung. Da die Düsenanordnung vorzugsweise in dem Behandlungsmedium angeordnet ist, wird gleichzeitig aus der Umgebung des Einlaufbereichs Behandlungsmedium angesaugt. Durch das angesaugte Behandlungsmedium entsteht im Einlaufbereich daraus ein Polster zu den Gehäusewänden der Düsenanordnung hin, so dass effektiv ein Kontakt des Behandlungsgutes mit den Gehäusewänden der Düsenanordnung vermieden wird.

Vorzugsweise sind Vorderkanten der Düsenanordnung im Einlaufbereich der Düsenanordnung angeschrägt oder abgerundet, um Wirbelbildungen, die das Behandlungsgut aus der Bahn lenken könnten, zu verhindern.

Die mindestens eine Düsenöffnung ist vorzugsweise derart ausgestaltet, dass sie sich über eine Breite in einer Breitenrichtung senkrecht zu der Transportrichtung entlang der Transportebene erstreckt. Die Breite ist dabei abhängig von einer entsprechenden Breite des Behandlungsgutes ausgewählt, so dass eine gleichmäßige flächige Behandlung des Behandlungsgutes gewährleistet ist. Die Düsenöffnung kann insbesondere schlitzförmig oder als eine Reihe nebeneinander voneinander beabstandet angeordneter Öffnungen ausgestaltet sein, so dass eine gleichmäßige Behandlung über die gesamte Breite des Behandlungsgutes gewährleistet ist. Die Düsenöffnung ist in dieser Richtung vorzugsweise parallel zu der Transportebene angeordnet.

Aufgrund der gewünschten Einsaugwirkung der Düsenanordnung besteht bei ungleichmäßiger Flüssigkeitsverteilung über die Breitenrichtung der Transportbahn die Gefahr, dass das Behandlungsgut einseitig eingezogen wird und damit die Transportbahn seitlich verlässt oder an seitlichen Begrenzungen der Transportbahn hängen bleibt.

Zur besseren Verteilung des Behandlungsmediums ist es daher vorteilhaft, wenn die Düsenanordnung einen sich entlang der mindestens einen Düsenöffnung erstreckenden Mediumkanal oder Flüssigkeitskanal zum Transport des Behandlungsmediums umfasst. Vorzugsweise ist der Mediumkanal mit der mindestens einen Düsenöffnung durch Verteileröffnungen, welche entlang der mindestens einen Düsenöffnung voneinander beabstandet angeordnet sind, verbunden. Die Verteileröffnungen stellen einen Strömungswiderstand dar und verbessern somit die Verteilung des Behandlungsmediums auf die gesamte Breite der Düsenöffnung. Vorzugsweise weisen die Verteileröffnungen einen gleichen Durchmesser und eine gleiche Länge, jedoch unterschiedliche Abstände auf. Es sind jedoch auch andere Konfigurationen möglich.

Gemäß einem Ausführungsbeispiel umfasst die Düsenanordnung einen in dem Mediumkanal angeordneten Einsatz, dessen Verdrängungsvolumen sich mit zunehmendem Abstand von einer Anschlussöffnung, welche zur Zuführung bzw. Ableitung des Behandlungsmediums vorgesehen ist, vergrößert. Hierdurch wird gewährleistet, dass sich ein Durchtrittsquerschnitt des Mediumkanals, d.h. eine zum Durchtritt des Behandlungsmediums verfügbare Querschnittsfläche, mit zunehmendem Abstand von der Anschlussöffnung verringert. Der Einsatz kann dabei derart gestaltet sein, dass sich der Durchtrittsquerschnitt entweder kontinuierlich oder in Stufen mit zunehmendem Abstand von der Anschlussöffnung verringert. Eine kontinuierliche Abnahme des Durchtrittsquerschnitts kann z.B. durch einen entsprechend geformten Einsatz oder durch eine entsprechende Zunahme einer Wandstärke eines Gehäuses des Mediumkanals erreicht werden. Eine stufenförmige Verringerung des Durchtrittsquerschnitts kann z.B. erreicht werden, indem der Einsatz aus einzelnen Abschnitten bzw. Segmenten zusammengesetzt wird. Bei diesen Segmenten kann es sich um einfache Verdrängungskörper oder aber auch um gelochte Körper handeln, wobei z.B. der Durchtrittsquerschnitt durch die Ausmaße des Loches bestimmt wird. Die einzelnen Segmente können verklebt, verschweißt, mit Spannstangen oder mit einer Versteifung zusammengehalten werden. Die stufenförmige Verringerung des Durchtrittsquerschnitts kann dabei insbesondere derart- ausgestaltet sein, dass die Stufen entsprechenden Verteileröffnungen zugeordnet sind, wobei vorzugsweise die Verringerung des Durchtrittsquerschnitts an einer Stufe entsprechend dem Strom des Behandlungsmediums durch die entsprechende Verteileröffnung angepasst ist. Der Durchtrittsquerschnitt des Mediumkanals kann somit an das in einer bestimmten Zeiteinheit durch den Mediumkanal fließende Volumen des Behandlungsmediums angepasst werden, so dass sich eine gleichmäßige Verteilung der Strömungsgeschwindigkeit und des Druckes ergibt. Die stufenförmige Zusammensetzung des Einsatzes aus einzelnen Segmenten bietet weiterhin den Vorteil von sehr niedrigen Herstellungskosten.

In diesem Zusammenhang ist es auch möglich, die Verteileröffnungen, welche den Mediumkanal mit der Düsenöffnung verbinden, mit unterschiedlicher Länge zu versehen, z.B. als Bohrungen in einer Gehäusewand mit einer stufenförmig gestalteten Wandstärke. Ebenso kann, wenn die mindestens eine Düsenöffnung eine Vielzahl von entlang der Breitenrichtung angeordneten Öffnungen umfasst, derart ausgestaltet sein, dass die einzelnen Öffnungen Kanäle oder Bohrungen unterschiedlicher Länge bilden. Durch die unterschiedlich lange Ausgestaltung der Verteileröffnung oder der nebeneinander angeordneten Öffnungen der mindestens einen Düsenöffnung ergeben sich unterschiedliche Strömungswiderstände, welche zu einer weiteren Angleichung der Strömungsgeschwindigkeit beitragen. Auch gleiche Lochdurchmesser bei unterschiedlichen Lochabständen sind möglich.

Die zuvor erwähnten Verteileröffnungen können alle denselben Durchmesser aufweisen. Im Sinne einer Anpassung der Strömungsgeschwindigkeit kann es jedoch auch vorteilhaft sein, die Verteileröffnungen mit unterschiedlichen Durchmessern auszugestalten. Dies bedeutet, dass die Durchmesser der Verteileröffnungen an die Strömungsgeschwindigkeiten im Mediumkanal und die damit verbundenen Druckverhältnisse angepasst werden können. Bei Verteileröffnungen mit unterschiedlichem Durchmesser können darüber hinaus Enden der Verteileröffnungen mit Ansenkungen versehen werden, welche wiederum einen gleichen Durchmesser aufweisen. Hierdurch erfolgt eine weitere Vergleichmäßigung der Strömungsgeschwindigkeit und insbesondere der Strömungsgeschwindigkeit beim Austritt aus den Verteileröffnungen.

Die oben beschriebenen Verteileröffnungen können in Form von entsprechenden Bohrungen des Einsatzes oder in einer Gehäusewand ausgebildet sein. Der Einsatz kann in seiner Längsrichtung, d.h. entlang der Transportrichtung mit einem U-förmigen Querschnitt ausgestaltet sein, so dass sich eine versteifte Gesamtform ergibt, welche durch Einklemmen in einem Gehäuse der Düsenanordnung gehalten werden kann.

Besonders vorteilhaft ist es, wenn im Falle einer schlitzförmigen Düsenöffnung, diese durch eine Gehäusewand und eine gegenüberliegende Einschubleiste gebildet wird. In diesem Fall kann zum Reinigen der Düsenanordnung die Einschubleiste entfernt werden und damit die an sich enge Düsenöffnung für Reinigungswerkzeuge leicht zugänglich gemacht werden.

Gemäß einem bevorzugten Ausführungsbeispiel der Erfindung kann der Querschnitt des Behandlungskanals durch eine entsprechende Formgebung an die gewünschte Strömungsgeschwindigkeit parallel zur Ebene des Behandlungsgutes angepasst werden. Dies erfolgt vorzugsweise durch die Einschubleiste, welche austauschbar ausgestaltet ist, so dass die Düsenanordnung mit geringem Aufwand an die Erfordernisse für ein bestimmtes Behandlungsgut angepasst werden kann.

Weiterhin kann durch die Formgebung des Behandlungskanals erreicht werden, dass in einem definierten Bereich ein Unterdruck erzeugt wird. Dies geschieht vorzugsweise ebenfalls mittels mindestens einer austauschbaren Einschubleiste. Durch den Unterdruck in einem definierten Bereich wird erreicht, dass das Behandlungsmedium dazu veranlasst wird, in oder durch Sacklöcher oder Durchgangslöcher des Behandlungsgutes zu strömen.

Erfindungsgemäß ist es somit vorgesehen, den Querschnitt des Behandlungskanals gezielt zu beeinflussen, um dadurch die Strömungsgeschwindigkeit einzustellen oder in einem definierten Bereich einen Unterdruck zu erzeugen. Die geschieht in bevorzugter Weise dadurch, dass an einer oder mehreren Positionen entlang der Transportrichtung innerhalb des Behandlungskanals gezielt eine Verengung des Behandlungskanals herbeigeführt wird.

Gemäß einem bevorzugten Ausführungsbeispiel ist der Austrittsquerschnitt der schlitzförmigen Düsenöffnung mittels einer Düsenschiene einstellbar. Die Düsenschiene, welche beispielsweise aus Metall oder Kunststoff gebildet ist, kann zu diesem Zweck justierbar an dem Gehäuse der Düsenanordnung angebracht sein. Besonders bevorzugt ist es, die Düsenschiene austauschbar zu gestalten, um unterschiedliche Geometrien der Düsenöffnung auswählen zu können. Auf diese Weise kann die Düsenanordnung in präziser und flexibler Weise an unterschiedliche Prozessanforderungen und unterschiedliche Typen von Behandlungsgut angepasst werden.

Vorzugsweise sind, wenn die mindestens eine Düsenöffnung durch mindestens einen Düsenöffnungskanal gebildet ist, welcher in einem spitzen Winkel bezüglich der Transportebene des Behandlungsgutes oder nahezu parallel dazu verläuft, auch die Verteileröffnung durch Verteilerkanäle oder Verteilerbohrungen gebildet, welche in einem Winkel bezüglich der Transportebene des Behandlungsgutes angeordnet sind, der größer ist als der Winkel der Düsenöffnungskanäle bezüglich der Transportebene. Außerdem können die Verteileröffnungen bzw. die Verteilerkanäle oder Verteilerbohrungen in der Transportrichtung des Behandlungsgutes versetzt gegenüber der mindestens einen Düsenöffnung angeordnet sein. Durch diese Maßnahmen erfolgt eine mehrfache Umlenkung des Stroms des Behandlungsmediums. Insbesondere kann hierdurch vermieden werden, dass aufgrund von dynamischen Kräften in dem Strom des Behandlungsmediums dieses an den Düsenöffnungen bei höheren Fließgeschwindigkeiten nicht in Richtung des Düsenöffnungskanals austritt.

Die erfindungsgemäße Düsenanordnung kann als Einzeldüsenanordnung mit einer Düsenöffnung auf einer Seite des Behandlungsgutes oder als beidseitige Düsenanordnung mit einer Düsenöffnung jeweils unterhalb und oberhalb des Behandlungsgutes ausgestaltet sein.

Besonders vorteilhaft ist es, wenn die Düsenanordnung mindestens eine weitere Düsenöffnung umfasst, welche auf einer der mindestens einen Düsenöffnung entgegengesetzt liegenden Seite der Transportebene des Behandlungsgutes angeordnet ist. Hierdurch kann das Behandlungsgut beim Durchlauf durch die Düsenanordnung von beiden Seiten, d.h. von einer Oberseite und einer Unterseite, behandelt werden. Dies ist insbesondere bei Behandlungsgut, welches eine beidseitige Behandlung erfordert, z.B. beidseitig bedruckte Leiterplatten oder Folien, von Vorteil. Speziell können hierdurch Behandlungsschritte eingespart werden und eine Gesamtbehandlungszeit verkürzt werden, so dass sich insgesamt ein geringerer Aufwand ergibt. Dabei ist es besonders vorteilhaft, die Düsenanordnung im Wesentlichen spiegelsymmetrisch bezüglich der Transportebene des Behandlungsgutes auszugestalten, so dass sich die oben beschriebenen Vorteile der Düsenanordnung auf beiden Seiten des Behandlungsgutes ergeben.

Zum Behandeln von Sacklöchern oder Durchgangslöchern in dem Behandlungsgut ist es weiterhin vorteilhaft, mindestens eine oder mehrere zusätzliche Düsenöffnungen vorzusehen, die das Behandlungsmedium im Wesentlichen senkrecht zu der Oberfläche des Behandlungsgutes abgeben. Diese zusätzlichen Düsenöffnungen können bezüglich der zuvor beschriebenen Düsenöffnungen, welche eine Strömungskomponente in der Transportrichtung bewirken, vorgelagert oder nachgelagert angeordnet sein. In dem Fall, dass Düsenöffnungen auf beiden Seiten der Ebene des Behandlungsgutes vorgesehen sind, können sich die zusätzlichen Düsenöffnungen, welche auf unterschiedlichen Seiten des Behandlungsgutes angeordnet sind, direkt gegenüberliegen oder gegeneinander versetzt sein. Die zusätzlichen Düsenöffnungen können einstellbar oder nicht einstellbar mit dem Behandlungsmedium versorgt werden. Dies kann über den gleichen Mediumkanal erfolgen, welcher zur Versorgung der zuvor beschriebenen Düsenöffnungen mit Strömungskomponente in Transportrichtung verwendet wird. Besonders vorteilhaft werden durch die zusätzlichen Düsenöffnungen Durchgangslöcher in dem Behandlungsgut behandelt, da an der zusätzlichen Düsenöffnung ein Überdruck entsteht, während z. B. auf der entgegengesetzten Seite des Behandlungsgutes ein Unterdruck im Behandlungskanal vorhanden ist. Alternativ kann auch eine separate Versorgung vorgesehen sein. Im letzteren Fall kann auch eine separate Fördereinrichtung oder -pumpe zum Fördern des Behandlungsmediums vorgesehen sein.

Es hat sich weiterhin gezeigt, dass der Transport des Behandlungsgutes durch den Behandlungskanal der Düsenanordnung verbessert werden kann, indem die Strömungskomponente in der Transportrichtung oder senkrecht zu der Ebene des Behandlungsgutes im Auslaufbereich der Düsenanordnung gezielt verringert wird. Dies wird bevorzugt dadurch erreicht, dass zusätzlich zu den zuvor beschriebenen Maßnahmen im Auslaufbereich der Düsenanordnung der Querschnitt des Behandlungskanals erweitert wird. Somit kann durch die Formgebung der Düsenanordnung bzw. des Behandlungskanals erreicht werden, dass die Strömungsgeschwindigkeit des Behandlungsmediums auf der Seite des Einlaufbereichs entlang der Transportrichtung stetig zunimmt, während auf der Seite des Auslaufbereichs die Strömungsgeschwindigkeit stetig abnimmt. Zusätzlich kann der Auslaufbereich mit strömungsbeeinflussenden Elementen versehen werden. Als strömungsbeeinflussende Elemente haben sich Erhebungen, Leitbleche oder Stege, welche in bzw. auf der Oberfläche der Düsenanordnung ausgebildet sind, als vorteilhaft erwiesen. Durch derartige strömungsbeeinflussende Elemente werden Strömungswirbel vermieden und somit die Strömungskomponente senkrecht zu der Ebene des Behandlungsgutes und in der Transportrichtung minimiert. Die strömungsbeeinflussenden Elemente können darüber hinaus eine zusätzliche Führungsfunktion für das Behandlungsgut gewährleisten.

Die vorliegende Erfindung, welche es vorsieht, gezielt eine Strömung des Behandlungsmediums in der Transportrichtung des Behandlungsgutes herbeizuführen, um dabei Behandlungsmedium aus dem Einlaufbereich der Düsenanordnung anzusaugen, unterstützt auf diese Weise effektiv den Transport des Behandlungsgutes durch den Behandlungskanal der Düsenanordnung. Es ist auf diese Weise sogar möglich, zum Beispiel bei sehr dünnem Behandlungsgut, das als so genanntes Endlosmaterial vorliegt, einen Transport ohne weiteren Antrieb durch beispielsweise Walzen, Räder, Klammern oder Ähnliches zu erreichen. Weiterhin gewährleistet das Ansaugen von Behandlungsmedium aus der Umgebung des Einlaufbereichs eine effektive Umwälzung des Behandlungsmediums. Der Volumenstrom, welche durch dieses Ansaugen von Behandlungsmedium in dem Einlaufbereich erreicht wird, ist wesentlich größer als derjenige, welcher durch die Düsenöffnungen allein erzeugt wird. Weiterhin ermöglicht die erfindungsgemäße Düsenanordnung einen berührungslosen Transport des Behandlungsgutes.

Die Düsenanordnung ist besonders geeignet zur Verwendung beim nasschemischen Behandeln von Leiterplatten oder Leiterfolien als Behandlungsgut als Teil einer entsprechenden Vorrichtung oder Anlage. Die Düsenanordnung bietet den Vorteil, dass das Behandlungsgut aufgrund der speziell gestalteten Strömungsverhältnisse nicht aus seiner vorgesehenen Transportbahn gelenkt wird. Dies gilt insbesondere in dem Einlaufbereich der Düsenanordnung. Die Düsenanordnung ermöglicht weiterhin eine gleichmäßige Strömungsgeschwindigkeit und Durchflussmenge des Behandlungsmediums entlang der Breite der Düsenanordnung, wodurch ein gleichmäßigeres Behandlungsergebnis erzielt wird. Zusätzlich ergibt sich eine gleichmäßige Strahl- bzw. Schwallgeometrie und insbesondere eine gleichmäßige Ausrichtung des Stroms des Behandlungsmediums an den Düsenöffnungen. Nicht zuletzt ermöglicht die Düsenanordnung eine hohe Kompaktheit sowie eine Fertigung aus einer geringen Anzahl von Bauteilen, wodurch der Platzbedarf in entsprechenden Vorrichtungen oder Anlagen bzw. die Fertigungskosten niedrig gehalten werden.

Die vorliegende Erfindung wird nachfolgend näher unter Bezugnahme auf die beigefügten Zeichnungen anhand von bevorzugten Ausführungsbeispielen erläutert.
Fig. 1A zeigt eine Schnittansicht eines Ausführungsbeispiels einer erfindungsgemäßen Düsenanordnung mit zwei Düsen im Teilquerschnitt entlang einer in Fig. 2 dargestellten Schnittlinie C-C';
Fig. 1B zeigt einen vergrößerten Ausschnitt einer der in Fig. 1A dargestellten Düsen;
Fig. 2 zeigt eine Schnittansicht des Ausführungsbeispiels von Fig. 1A im Teilquerschnitt entlang einer in Fig. 1A dargestellten Schnittlinie A-A';
Fig. 3 zeigt eine Schnittansicht des Ausführungsbeispiels von Fig. 1A im Teilquerschnitt entlang einer in Fig. 1A dargestellten Schnittlinie B-B';
Fig. 4 zeigt eine Schnittansicht eines weiteren Ausführungsbeispiels der erfindungsgemäßen Düsenanordnung entlang einer in Fig. 5 dargestellten Schnittlinie C-C';
Fig. 5 zeigt eine Schnittansicht des Ausführungsbeispiels von Fig. 4 im Teilquerschnitt entlang einer in Fig. 4 dargestellten Schnittlinie B-B';
Fig. 6 zeigt eine Schnittansicht des Ausführungsbeispiels von Fig. 4 im Teilquerschnitt entlang einer in Fig. 4 dargestellten Schnittlinie A-A'.
Fig. 7 zeigt eine Schnittansicht eines weiteren Ausführungsbeispiels der erfindungsgemäßen Düsenanordnung mit einer einstellbaren Düsenschiene;
Fig. 8 zeigt eine weiteres Ausführungsbeispiel der erfindungsgemäßen Düsenanordnung mit zusätzlichen Düsenöffnungen; und
Fig. 9 zeigt ein weiteres Ausführungsbeispiel der erfindungsgemäßen Düsenanordnung, wobei Teile der Düsenanordnung, welche zu beiden Seiten einer Transportebene angeordnet sind, unterschiedlich ausgestaltet sind.

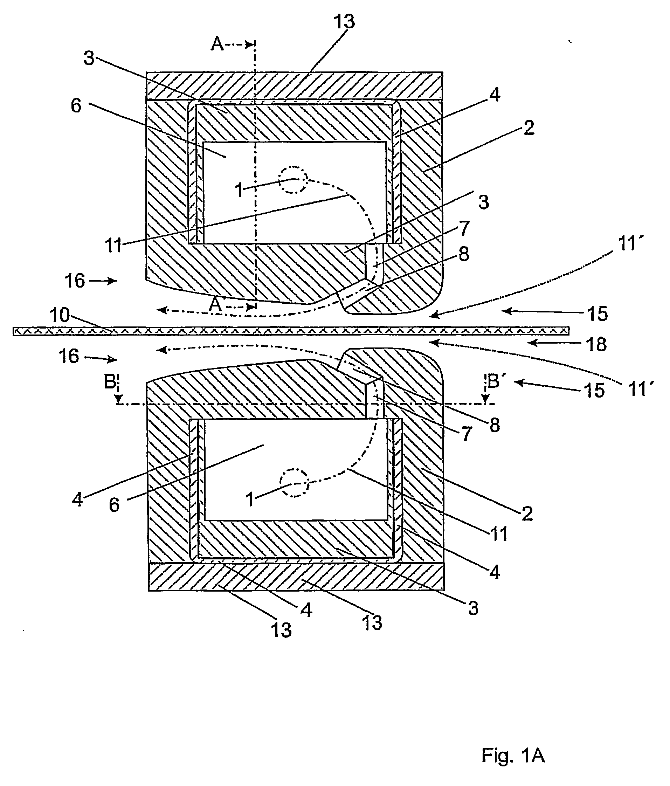

In Fig. 1A ist eine Düsenanordnung gemäß einem Ausführungsbeispiel der vorliegenden Erfindung dargestellt, welche sich insbesondere als Schwalldüse für Galvanisierungsanlagen mit einem horizontalen Durchlauf von Leiterplatten oder Leiterfolien eignet. Die Düsenanordnung umfasst zwei Düsen, die sich entlang einer Transportebene, in welcher ein Behandlungsgut entlang einer Transportbahn von einem Einlaufbereich 15 zu einem Auslaufbereich 16 transportiert wird, erstrecken. Die zwei Düsen sind einander unmittelbar gegenüberliegend bezüglich der Transportebene spiegelbildlich angeordnet. Zwischen den zwei Düsen entsteht ein Behandlungskanal, durch den das Behandlungsgut geführt werden kann.

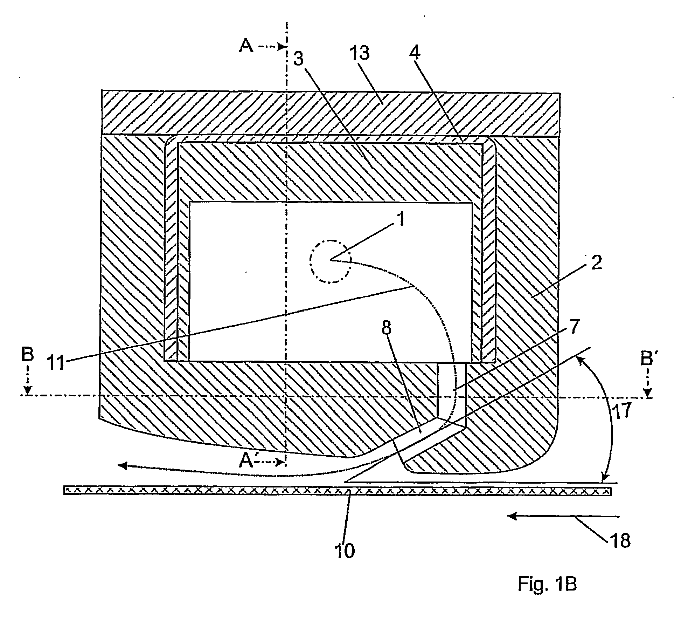

Die Düsen umfassen jeweils ein Gehäuse 2, in dessen der Transportebene zugewandten Seite eine Düsenöffnung 8 vorgesehen ist. Ein Behandlungsmedium in Form einer Behandlungsflüssigkeit zur Behandlung des Behandlungsgutes wird der Düse durch eine Anschlussöffnung 1, welche an einer Stirnseite der Düsen angeordnet ist, zugeführt. Von der Anschlussöffnung 1 gelangt die Behandlungsflüssigkeit in einen Mediumkanal in Form eines Flüssigkeitskanals 6, welcher mit der Düsenöffnung durch Verteileröffnungen 7 verbunden ist. Ein Flüssigkeitsstrom der Behandlungsflüssigkeit ist in Fig. 1 durch Pfeile 11 und 11' veranschaulicht.

Das Gehäuse 2 der Düsen umfasst jeweils eine Seitenwand auf einer Seite des Einlaufbereichs 15 und eine Seitenwand auf einer Seite des Auslaufbereichs 16 der Düsenanordnung. Das Gehäuse 2 der Düsen wird jeweils durch einen Gehäusedeckel 13 abgeschlossen, so dass das Gehäuse 2 zusammen mit dem Gehäusedeckel 13 den Flüssigkeitskanal 6 umschließt. In dem Flüssigkeitskanal 6 ist ein Einsatz 3 mit U-förmigem Querschnitt angeordnet. Die offene Seite des Einsatzes 3 ist dabei auf einer Seite der Düsenöffnung 8 in dem Gehäuse 2 angeordnet, so dass die Verteileröffnungen 7 von dem Flüssigkeitskanal 6 aus frei zugänglich sind. Der Einsatz ist vorzugsweise aus Kunststoff gefertigt und an seiner Außenseite mit einer ebenfalls U-förmigen Versteifung 4 zur Stabilisierung der Düse und des Gehäuses 2 versehen. Die U-förmige Versteifung 4 besteht vorzugsweise aus einem gegen die verwendeten Chemikalien beständigen Metall, wie z.B. Edelstahl, Titan, Niob oder dergleichen.

Das Behandlungsgut 10 durchläuft die Düsenanordnung in der horizontalen Transportebene in einer durch den Pfeil 18 bezeichneten Transportrichtung. Dabei wird die Behandlungsflüssigkeit aus den Düsenöffnungen 8 schräg auf das Behandlungsgut 10 geleitet. Hierdurch entsteht eine Sogwirkung auf der Seite des Einlaufbereichs 15 der Düsenanordnung. Die Düsenanordnung ist in einem flüssigen Medium angeordnet, wobei es sich z.B. um die Behandlungsflüssigkeit handeln kann, so dass aufgrund der Sogwirkung weitere Flüssigkeit, wie durch die Pfeile 11' angedeutet, in den Behandlungskanal angesaugt wird.

Fig. 1B zeigt eine vergrößerte Teilansicht einer der Düsen aus Fig. 1A. Hierin ist insbesondere ersichtlich, dass die Düsenöffnung 8 durch einen Düsenöffnungskanal gebildet ist, welcher einen spitzen Winkel 17 bezüglich der Transportebene des Behandlungsgutes 10 bildet. Der Winkel 17 öffnet sich entgegen der Transportrichtung 18, so dass die Behandlungsflüssigkeit durch den Düsenöffnungskanal in Richtung der Transportrichtung 18 umgelenkt wird. Die Verteileröffnungen 7 sind jeweils durch einen Verteilerkanal in Form von Bohrungen in dem Gehäuse 2 gebildet, welcher in einem Winkel bezüglich der Transportebene angeordnet ist, der größer ist als der Winkel 17 des Düsenöffnungskanals. Der Flüssigkeitsstrom wird somit, wie durch den Pfeil 11 angedeutet, mehrfach in Richtung der Transportrichtung 18 des Behandlungsgutes 10 umgelenkt.

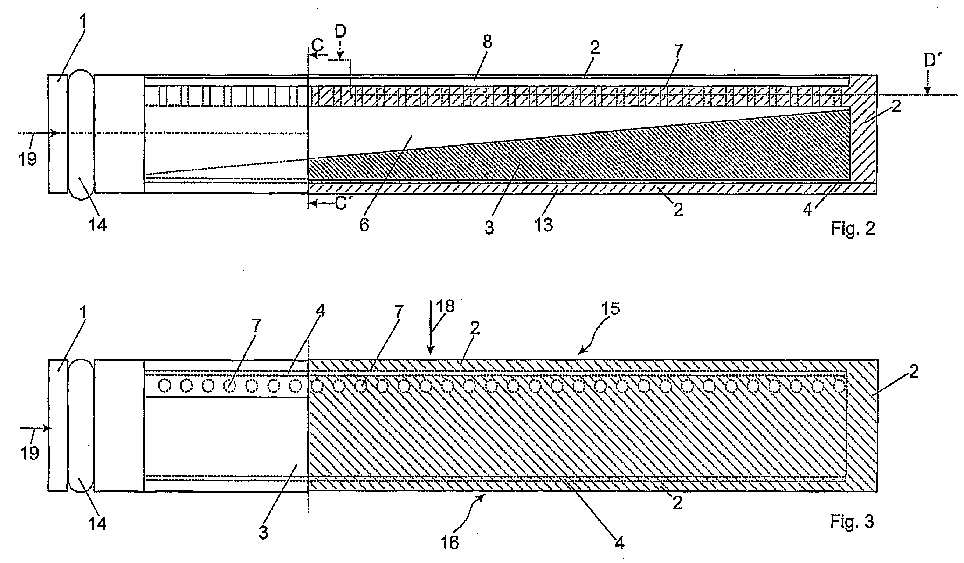

Fig. 2 zeigt eine Schnittansicht der Düsenanordnung von Fig. 1A und Fig. 1B in Form eines Teilquerschnitts entlang einer in Fig. 1A dargestellten Schnittlinie A-A', d.h. entlang einer Breitenrichtung der Düsenanordnung. Wie aus Fig. 2 ersichtlich ist, ist die Anschlussöffnung 1 in Form eines Anschlussstutzens mit einem Dichtring 14 ausgestaltet, durch welchen die Behandlungsflüssigkeit in den Flüssigkeitskanal 6 eintritt. Insbesondere ist ersichtlich, dass der Einsatz 3 keilförmig ausgebildet ist, so dass sich ein Durchtrittsquerschnitt des Flüssigkeitskanals mit zunehmendem Abstand von der Anschlussöffnung 1 verringert. Weiterhin ist erkennbar, dass die Verteileröffnungen 7 als voneinander gleichmäßig beabstandete Bohrungen in einer Wand des Gehäuses 2 ausgebildet sind. Die Dicke dieser Wand ist entlang der Breite der Düse im Wesentlichen konstant, so dass sich für die Verteileröffnungen 7 eine im Wesentlichen gleiche Länge der Verteilerbohrungen ergibt.

Wie aus Fig. 2 ersichtlich, ist die Düsenöffnung 8 als ein sich entlang der Breitenrichtung der Düse erstreckender Schlitz ausgestaltet.

Fig. 3 zeigt eine Schnittansicht der Düsenanordnung von Fig. 1A, Fig. 1 B und Fig. 2 in Form eines Teilquerschnitts entlang einer in Fig. 1A dargestellten Schnittlinie B-B'. Wie aus Fig. 3 ersichtlich ist, handelt es sich bei den Verteileröffnungen 7 um voneinander in gleichmäßigen Abständen angeordnete Bohrungen mit rundem Querschnitt. Insbesondere sind die Verteileröffnungen 7 in einer Reihe nebeneinander angeordnet, welche sich an einer dem Einlaufbereich 15 zugewandten Seite der Düse befindet.

Der in Fig. 1A und 1B durch die Pfeile 11 angedeutete Flüssigkeitsstrom führt somit aus dem keilförmig gestalteten Flüssigkeitskanal 6 durch die Verteileröffnungen 7 in Form von Verteilerbohrungen mit rundem Querschnitt durch die als gleichmäßig breiter Schlitz ausgestaltete Düsenöffnung 8 auf das Behandlungsgut 10. Zwischen den Verteilerbohrungen und der Düsenöffnung 8 erfolgt eine Umformung des Flüssigkeitsstroms in einen Flachstrahl, welcher sich im Wesentlichen über die gesamte Breite des Behandlungsgutes erstreckt.

Durch den keilförmigen Einsatz 3 wird gewährleistet, dass die Strömungsgeschwindigkeit an allen Stellen des Flüssigkeitskanals 6 gleich hoch ist. Da alle Verteileröffnungen 7 gleiche Abmessungen aufweisen, entsteht somit ein sehr gleichmäßiges Spritzbild, d.h. eine gleichmäßige Strahl- bzw. Schwallgeometrie sowie eine gleichmäßige Ausrichtung des Flüssigkeitsstroms ist gewährleistet.

Die gleichmäßige Geometrie des Flüssigkeitsstroms ist insbesondere für die Erzeugung eines Sogeffektes durch den so genannten Venturi-Effekt von besonderer Bedeutung, weil bei ungleichmäßigem Sog entlang der Breitenrichtung das Behandlungsgut schräg eingezogen wird und dabei an einer seitlichen Begrenzung der Transportbahn hängen bleiben kann.

Hierfür weisen die Düsen bzw. die Düsenanordnung gemäß dem dargestellten Ausführungsbeispiel folgende Merkmale auf:
A) Die Düsenöffnung 8 ist nicht mittig, sondern an einer seitlichen Längskante der Düse in der Nähe des Einlaufbereichs 15 angeordnet.
B) Die Düsenöffnung 8 ist in Form eines Düsenöffnungskanals ausgestaltet, welcher, wie in Fig. 1B dargestellt, in einem spitzen Winkel 17 bezüglich der Transportebene des Behandlungsgutes 10 angeordnet ist.
C) Die Dicke der Gehäusewand, welche der Transportebene zugewandt ist, verringert sich in einem Abschnitt zwischen der Düsenöffnung 8 und dem Auslaufbereich 16, so dass der Behandlungskanal sich in diesem Abschnitt in der Transportrichtung 18 keilförmig verbreitert.
D) Kanten der Düse im Einlaufbereich 15 und Auslaufbereich 16 sind abgerundet, um Wirbelbildungen in der Behandlungsflüssigkeit zu vermeiden.
E) In einem Abschnitt zwischen dem Einlaufbereich 15 und der Düsenöffnung 8 vergrößert sich die Dicke der Gehäusewand, welche der Transportebene zugewandt ist, so dass der Behandlungskanal sich in diesem Abschnitt in der Transportrichtung 18 keilförmig verengt.

Dies bedeutet insbesondere, dass sowohl der Einlaufbereich als auch der Auslaufbereich bei der in Fig. 1A gezeigten spiegelsymmetrischen Düsenanordnung eine Trichterform aufweisen.

Durch diese spezielle Formgebung der dem Behandlungsgut zugewandten Düsengeometrie wirkt in dem Einlaufbereich 15 der Düsenanordnung ein Unterdruck, welcher aus der Umgebung der Düsenanordnung Flüssigkeit und das Behandlungsgut in den Behandlungskanal, wie durch die Pfeile 11' in Fig. 1A angedeutet, einsaugt. Insbesondere durch die Keilform bzw. Trichterform des Behandlungskanals im Einlaufbereich 15 wird die Strömungsgeschwindigkeit zur Düsenöffnung 8 hin erhöht. Durch die Strömung und die abgerundeten Kanten der Düse wird sichergestellt, dass insbesondere dünnes Behandlungsgut nicht gegen die Seitenwände der Düsen stößt. Durch die Sogwirkung der Düsenanordnung im Einlaufbereich 15 wird mehr Behandlungsflüssigkeit durch den Behandlungskanal gezogen als durch die Düsenöffnungen 8 ausströmt. Dies verhindert nicht nur die Beschädigung des Behandlungsgutes sondern beschleunigt auch die Behandlung, wodurch kürzere Behandlungszeiten als mit herkömmlichen Düsenanordnungen erreicht werden können. So wird durch den Unterdruck z.B. erreicht, dass in Sacklöchern vorhandene Luft oder durch die Behandlung gebildetes Gas ausgesaugt wird und damit die Benetzung der Oberfläche mit Behandlungsflüssigkeit verbessert wird.

Im Auslaufbereich der Düsenanordnung wird die Strömungsgeschwindigkeit mit zunehmender Verbreiterung des Behandlungskanals geringer.

Sowohl auf der Seite des Einlaufbereichs 15 als auch auf der Seite des Auslaufbereichs 16 können neben der Düsenanordnung Transportwalzen angeordnet sein. Die Transportwalzen gewährleisten einen sicheren Transport des Behandlungsgutes von oder zu benachbarten Behandlungsstationen.

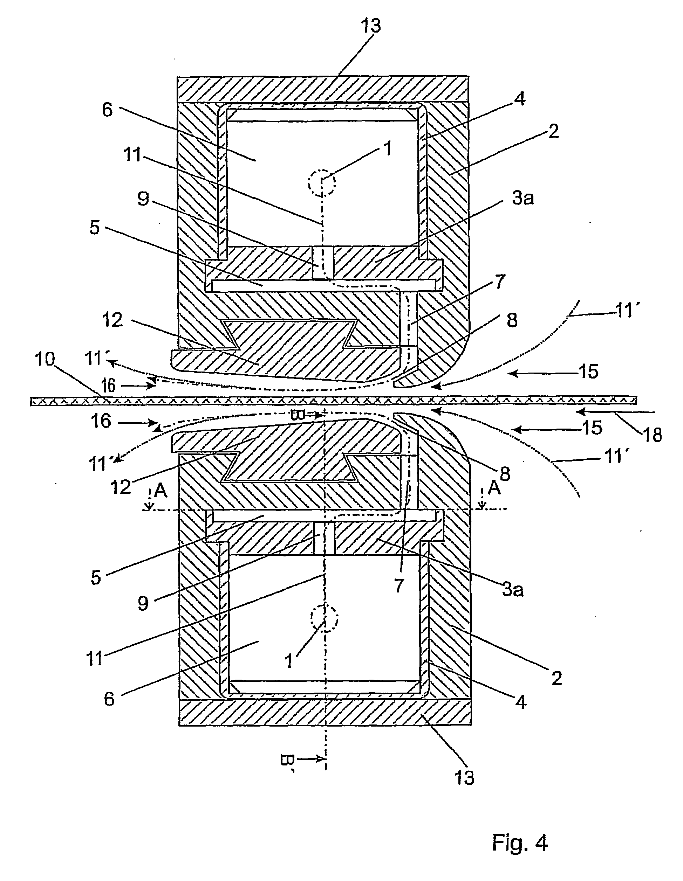

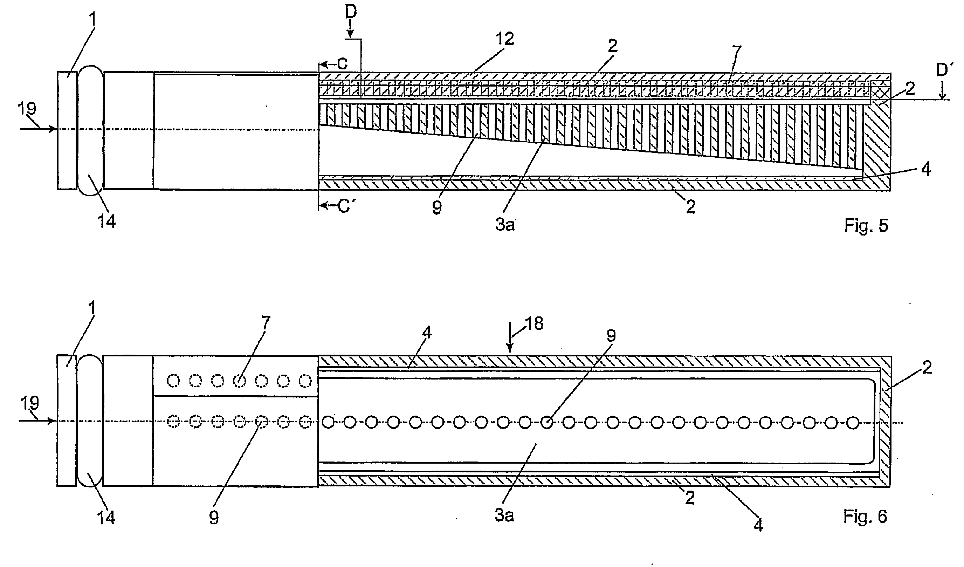

Fig. 4 zeigt eine Schnittansicht einer Düsenanordnung gemäß einer weiteren, besonders bevorzugten Ausführungsform der vorliegenden Erfindung. Bei Fig. 4 handelt es sich um einen Teilquerschnitt entlang einer in Fig. 5 mit C-C' bezeichneten Linie. Dem Ausführungsbeispiel von Fig. 1-3 ähnliche Merkmale und Komponenten der Düsenanordnung sind mit den gleichen Bezugszeichen bezeichnet und auf ihre Erläuterung wird im Folgenden verzichtet.

Im Unterschied zu dem anhand von Fig. 1-3 beschriebenen Ausführungsbeispiel weist die Düsenanordnung von Fig. 4 in dem Flüssigkeitskanal 6 einen auf der Seite der Düsenöffnung 8 angeordneten Einsatz 3a auf. In dem Einsatz 3a sind erste Verteilerbohrungen 9 vorgesehen, durch welche die Behandlungsflüssigkeit aus dem Flüssigkeitskanal 6 in einen Umlenkkanal 5 geleitet wird. Der Umlenkkanal 5 entsteht durch eine entsprechende Vertiefung des Einsatzes 3a. Von dort gelangt die Behandlungsflüssigkeit durch zweite Verteileröffnungen 7, welche im Wesentlichen den Verteileröffnungen des Ausführungsbeispiels von Fig. 1-3 entsprechen, zu den Düsenöffnungen 8. Die ersten Verteileröffnungen 9 sind gegenüber den zweiten Verteileröffnungen 7 und der Düsenöffnung 8 in der Transportrichtung 18 versetzt angeordnet. Hierdurch erfolgt eine erste Umlenkung des Flüssigkeitsstroms um ungefähr 90° von der ersten Verteileröffnung 9 in den Umlenkkanal 5 und eine zweite Umlenkung um ungefähr 90° von dem Umlenkkanal 5 in die zweite Verteileröffnung 7. Eine dritte Umlenkung erfolgt, wenn die Behandlungsflüssigkeit aus der zweiten Verteileröffnung 7 in den Düsenöffnungskanal geleitet wird. Hierdurch wird die gewünschte Ausrichtung des Flüssigkeitsstroms schräg zur Transportebene des Behandlungsgutes 10 auch bei höheren Fließgeschwindigkeiten der Behandlungsflüssigkeit gewährleistet.

Bei der in Fig. 4 dargestellten Düsenanordnung wird eine dem Behandlungsgut 10 zugewandte Oberfläche der Düse durch eine Einschubleiste 12 gebildet. Die Einschubleiste 12 hat eine schwalbenschwanzförmige Führung, welche in das an dieser Seite ebenfalls schwalbenschwanzförmig gestaltete Gehäuse 2 der Düse eingeschoben ist. Die Düsenöffnung 8 wird auf einer Seite durch eine Kante der Einschubleiste 12 und auf der anderen Seite durch eine gegenüberliegende Kante des Gehäuses 2 gebildet, so dass sich wiederum eine schlitzartige entlang der Breite der Düse angeordnete Düsenöffnung 8 ergibt. Die der Transportebene des Behandlungsgutes 10 zugewandte Seite der Einschubleiste weist im Wesentlichen dieselbe Formgebung auf, wie sie zuvor für die entsprechende Gehäusewand der Düsenanordnung von Fig. 1-3 beschrieben worden ist. Hierdurch wird gewährleistet, dass dieselben vorteilhaften Strömungseffekte erzielt werden.

Zum Reinigen der Düse kann die Einschubleiste 12 entfernt werden, so dass die zweiten Verteileröffnungen 7 frei zugänglich sind.

Fig. 5 zeigt eine Schnittansicht der Düsenanordnung von Fig. 4 in Form eines Teilquerschnitts entlang einer in Fig. 4 dargestellten Schnittlinie B-B'. Aus Fig. 5 ist insbesondere ersichtlich, dass die ersten Verteileröffnungen 9 in dem Einsatz 3a voneinander gleichmäßig beabstandet entlang der Breitenrichtung der Düsenanordnung angeordnet sind. Durch die Keilform des Einsatzes 3a ergeben sich für die einzelnen ersten Verteileröffnungen 9 jeweils unterschiedliche Längen der Verteilerbohrungen. Die Keilform des Einsatzes 3a ist dabei wiederum derart gestaltet, dass sich der Durchtrittsquerschnitt des Flüssigkeitskanals 6 mit zunehmendem Abstand von der Anschlussöffnung 1 verringert. Das heißt, dass mit zunehmender Entfernung von der Anschlussöffnung 1 die Verteilerbohrungen länger werden, wodurch sich auch ein größeres Druckgefälle über die Verteilerbohrungen ergibt. Dies hat insbesondere zu dem der Anschlussöffnung 1 gegenüberliegenden Ende des Flüssigkeitskanals 6 hin eine ausgleichende Wirkung. Weiterhin ist die Keilform des Einsatzes 3a derart gestaltet, dass die verbleibende Höhe des Flüssigkeitskanals an diesem Ende nicht Null ist, sondern an dieser von der Anschlussöffnung 1 am weitesten entfernten Stelle einen endlichen Wert von vorzugsweise 2-8 mm aufweist.

Fig. 6 zeigt eine Schnittansicht der Düsenanordnung von Fig. 4 und 5 in Form eines Teilquerschnitts entlang einer in Fig. 4 dargestellten Schnittlinie A-A'. Aus Fig. 6 ist ersichtlich, dass die ersten Verteileröffnungen 9 bezüglich der Transportrichtung 18 entlang einer Reihe mittig in der Düse angeordnet sind. Die zweiten Verteileröffnungen 7 sind jedoch wie bereits anhand des Ausführungsbeispiels von Fig. 1-3 erläutert in Richtung des Einlaufbereichs versetzt angeordnet. Hierdurch ergibt sich die bereits erwähnte vorteilhafte mehrfache Umlenkung des Flüssigkeitsstroms. Bei den ersten und zweiten Verteileröffnungen 7, 9 handelt es sich, wie aus Fig. 6 ersichtlich, um Verteilerbohrungen mit kreisförmigem Querschnitt. Bei diesem Ausführungsbeispiel weisen die ersten und die zweiten Verteileröffnungen 7, 9 gleiche Durchmesser auf. Es kann jedoch auch vorteilhaft sein die zweiten Verteileröffnungen 7 mit einem Durchmesser zu gestalten, welcher sich von dem Durchmesser der ersten Verteileröffnungen 9 unterscheidet. Weiterhin kann es auch vorteilhaft sein, wenn die ersten Verteileröffnungen 9 bzw. die zweiten Verteileröffnungen 7 jeweils untereinander verschiedene Durchmesser oder unterschiedliche Abstände zueinander aufweisen.

Mit der zuletzt beschriebenen Ausführungsform der Düsenanordnung wurden in mehreren Versuchen mit verschieden dicken Leiterfolien sehr gute Ergebnisse erzielt. Es hat sich dabei gezeigt, dass, sobald die Leiterfolien von dem Sog erfasst wurden, die Transportgeschwindigkeit der Leiterfolien durch den Unterdruck erheblich erhöht wurde. Trotz der hohen Transportgeschwindigkeit traten an den Leiterfolien keine Beschädigungen auf. Bei zusätzlichem Einsatz von Transportwalzen konnte beobachtet werden, dass selbst verbogene Leiterfolien durch die Sogwirkung in die Düsenanordnung hinein gestreckt wurden und ohne Beschädigung oder Stau die Düsenanordnung auf einer vorbestimmten Transportbahn durchliefen.

Es sei an dieser Stelle darauf hingewiesen, dass bereits durch die Realisierung lediglich eines Teils der zuvor beschriebenen Maßnahmen bzw. Merkmale der Düsenanordnung eine für den jeweiligen Anwendungsfall ausreichende gleichmäßige Zufuhr von Behandlungsflüssigkeit und Sogwirkung erzielt werden kann, um das Behandlungsgut während der chemischen Behandlung sicher durch die Düsenanordnung zu führen.

Selbstverständlich ist auch eine Reihe von Modifikationen der in den Figuren dargestellten Ausführungsbeispiele denkbar, ohne von dem Grundgedanken der vorliegenden Erfindung abzuweichen.

So könnte beispielsweise die Anschlussöffnung 1 in der Mitte des Gehäuses 2 bezüglich der Breitenrichtung der Düsenanordnung angeordnet sein, so dass die Zufuhr der Behandlungsflüssigkeit mittig erfolgt. Bei dieser Variante würde dann der Durchtrittsquerschnitt des Flüssigkeitskanals 6 im Inneren des Gehäuses 2 ausgehend von der mittigen Anschlussöffnung 1 zu den beiden Enden der Düsenanordnung hin, d.h. beidseitig, abnehmen und sich die Dicke des Einsatzes 3 bzw. 3a entsprechend ausgehend von der mittigen Anschlussöffnung 1 zu den beiden Enden hin vergrößern, so dass auch die Länge der Verteilerbohrungen 9 in dem Einsatz 3a beidseitig zunimmt.

Des Weiteren wird bei den dargestellten Ausführungsbeispielen der sich kontinuierlich reduzierende Durchtrittsquerschnitt des Flüssigkeitskanals 6 alleine durch die zunehmende Höhe des Einsatzes 3 bzw. 3a realisiert. Selbstverständlich ist es auch denkbar, dass mehrere Seitenwände des Flüssigkeitskanals 6 in der Breitenrichtung der Düse eine zunehmende Wandstärke aufweisen. Darüber hinaus kann bei geringeren Anforderungen auf den Umlenkkanal 5 zur weiteren Druckverteilung verzichtet werden.

Zur Verbesserung der Gleichmäßigkeit der Strömungsgeschwindigkeit können die schlitzartig ausgebildeten Düsenöffnungen 8 auch mit einer variablen Weite versehen werden, wobei die Weite insbesondere in einer Breitenrichtung der Düse ausgehend von der Anschlussöffnung 1 abnehmen kann.

Wie bereits erwähnt, können die Verteileröffnungen 7 oder 9 auch mit unterschiedlichen Durchmessern ausgestaltet sein, wobei insbesondere zur Realisierung eines kontinuierlich zunehmenden Strömungswiderstandes eine entsprechende Reduzierung der Durchmesser der Verteileröffnungen 7 oder 9 denkbar ist.

An der an den Flüssigkeitskanal 6 angrenzenden Seite der Verteileröffnungen 7 bzw. 9 können diese auch mit Ansenkungen mit einem größeren Durchmesser versehen werden. Zur Realisierung eines in der Breitenrichtung der Düse kontinuierlich zunehmenden Strömungswiderstands können diese Ansenkungen mit einer unterschiedlichen Tiefe, insbesondere mit einer in der Breitenrichtung der Düse kontinuierlich zunehmenden Tiefe, versehen werden.

Weiterhin ist es auch möglich, den Abstand der Verteileröffnungen in solcher Weise zu variieren, dass die Verteileröffnungen nahe der Anschlussöffnung 1 einen geringeren Abstand aufweisen als diejenigen, welche von der Anschlussöffnung 1 weiter entfernt sind.

Auf die in den Figuren dargestellte Versteifung 4 kann gegebenenfalls auch verzichtet werden, wenn z.B. stattdessen eine dickere Gehäusewand verwendet wird. Ebenso ist es denkbar, dass der Einsatz 3 bzw. 3a und das Gehäuse 2 einteilig ausgestaltet sind. Schließlich sollte auch darauf hingewiesen werden, dass bei den dargestellten Ausführungsbeispielen zwar nur eine in der Breitenrichtung der Düse verlaufende schlitzartige Düsenöffnung 8 vorgesehen ist, jedoch auch mehrere in der Breitenrichtung der Düse angeordnete Schlitze, welche z.B. gleichmäßig voneinander beabstandet nebeneinander angeordnet sind, eingesetzt werden. Gegebenenfalls können auch nebeneinander angeordnete runde Öffnungen verwendet werden.

Weiterhin ist es möglich, den keilförmig verlaufenden Behandlungskanal zwischen einer Düse und dem Behandlungsgut 10 bzw. den trichterförmigen Verlauf des Behandlungskanals zwischen den beiden Düsen durch eine schräge Anordnung der Düsen und eine entsprechende Anpassung der jeweils gegenüberliegenden Oberfläche herzustellen. Insbesondere können hierbei auch asymmetrische Anordnungen von oberer und unterer Düse von Vorteil sein.

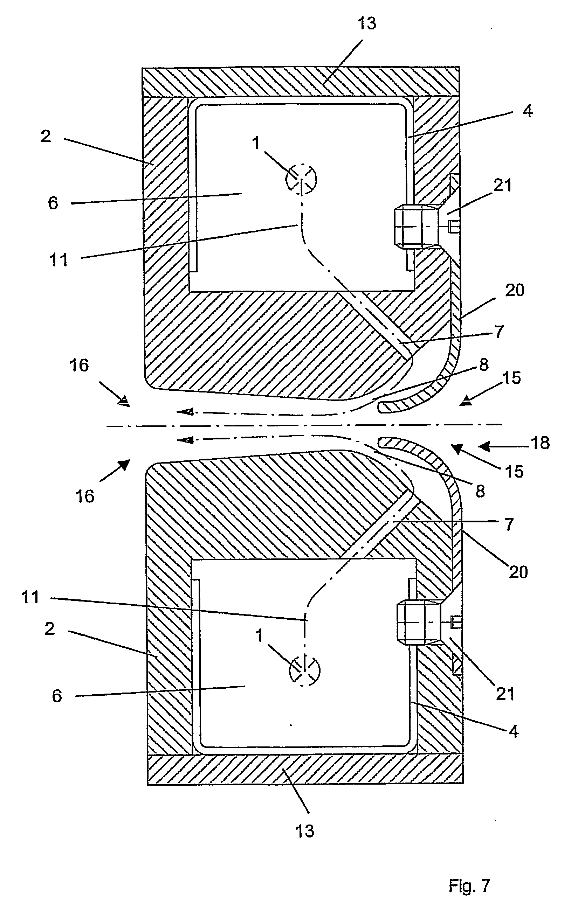

Fig. 7 zeigt ein weiteres Ausführungsbeispiel der erfindungsgemäßen Düsenanordnung, welches grundsätzlich demjenigen entspricht, welches anhand von Fig. 1A beschrieben wurde. Ähnliche Komponenten sind mit den gleichen Bezugszeichen bezeichnet. Im Unterschied zu Fig. 1A ist jedoch die Düsenöffnung 8 in justierbarer Weise ausgestaltet. Die Verteileröffnungen 7 verlaufen schräg bezüglich der Transportrichtung 18 von dem Flüssigkeitskanal 6 in Richtung des Einlaufbereichs 15 der Düsenanordnung. Die Verteileröffnungen 7 weisen einen entlang der Breitenrichtung der Düsenanordnung variierenden Abstand auf, welche mit zunehmendem Abstand von der Anschlussöffnung 1 größer wird.

An einer vorderen Gehäusewand des Gehäuses 2 ist eine Düsenschiene 20 justierbar angebracht. Die Düsenschiene 20 erstreckt sich entlang der vorderen Gehäusewand zunächst in einer Richtung senkrecht zu der Transportebene des Behandlungsgutes 10, um dann in einen Vorderkantenbereich überzugehen, der sich in die Transportrichtung wendet. Eine Innenfläche des Vorderkantenbereichs der Düsenschiene 20 ist der Verteileröffnung 7 zugewandt, während eine Außenfläche des Vorderkantenbereichs eine Vorderkante des Einlaufbereichs 15 der Düsenanordnung bildet und dem Behandlungsgut 10 zugewandt ist. Die Düsenöffnung 8 wird somit durch die Düsenschiene 20 und eine Gehäusewand begrenzt.

Die Düsenschiene 20 ist an der Gehäusewand justierbar angebracht. Insbesondere kann die Düsenschiene 20 mittels einer Einstellschraube 21 in einer Richtung senkrecht zu der Transportebene verschoben werden. Die justierbare Anbringung kann beispielsweise durch ein Langloch in der Düsenschiene 20, durch welches die Einstellschraube 21 durchgeführt ist, gewährleistet sein. Auf diese Weise kann durch Lösen der Einstellschraube 21, ein Verschieben der Düsenschiene 20 und anschließendes Anziehen der Einstellschraube 21 die Düsenschiene 20 in eine neue Position verschoben werden, wodurch zum einen der Querschnitt der Düsenöffnung 8 verändert wird und zum anderen der Abstand der Außenfläche des Vorderkantenbereichs zu der Transportebene des Behandlungsgutes 10 verändert wird. Somit kann mittels der Düsenschiene 20 sowohl der Querschnitt der Düsenöffnung 8 als auch der Querschnitt des Behandlungskanals im Einlaufbereich 15 eingestellt werden. Selbstverständlich sind auch andere Ausführungen der justierbaren Anbringung der Düsenschiene 20 denkbar. Beispielsweise kann die Gehäusewand, an welcher die Düsenschiene 20 angebracht ist, bezüglich der Transportebene schräg verlaufen.

Weiterhin kann auch die Düsenschiene 20 in unterschiedlicher Weise geformt sein. Dies betrifft insbesondere den Vorderkantenbereich, welcher sich in die Transportrichtung 18 des Behandlungsgutes 10 wendet. So können für den Vorderkantenbereich unterschiedliche Krümmungen vorgesehen sein. Bei einer schrägen Anbringung der Düsenschiene 20 ist auch ein grundsätzlich ungekrümmter Verlauf der Düsenschiene 20 denkbar.

Bevorzugt sind für verschiedene Typen von Behandlungsgut und für verschiedene Prozessanforderungen unterschiedliche Arten von Düsenschienen 20 vorgesehen, welche austauschbar an dem Gehäuse 2 der Düsenanordnung anbringbar sind. Auf diese Weise wird die Präzision und Flexibilität der Anpassung der Düsenanordnung an die jeweiligen Erfordernisse erhöht.

Wie in Fig. 1A ist die Düsenanordnung beidseitig bezüglich der Transportebene des Behandlungsgutes angeordnet. Speziell bedeutet dies, dass eine Düse oberhalb der Transportebene und eine Düse unterhalb der Transportebene angeordnet ist. Selbstverständlich ist es jedoch auch möglich, dass die Düsenanordnung nur eine Düse umfasst, welche auf einer Seite des Behandlungsgutes angeordnet ist, entsprechend Fig. 1B. Darüber hinaus kann die in Fig. 7 dargestellte Düsenanordnung auch mit einer Einschubleiste versehen sein, wie es anhand von Fig. 4 beschrieben wurde. In diesem Fall wird die Düsenöffnung 8 durch die Kante der Düsenschiene 20 und die Einschubleiste 12 begrenzt.

Wenn die Düsenanordnung nur an einer Seite der Transportebene angeordnet ist, kann das Behandlungsgut auf der Gegenseite durch z. B. Rollen, Räder oder Führungsschienen zusätzlich gestützt werden. Der Unterdruck auf der einen Seite des Behandlungsgutes führt zu einer guten Durchspülung selbst von kleinsten Durchgangslöchern im Behandlungsgut.

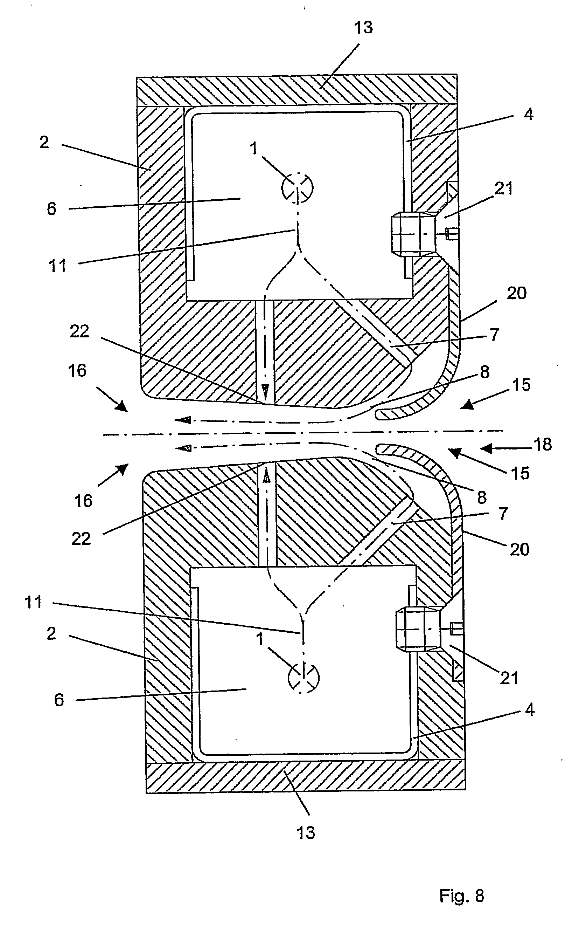

Fig. 8 zeigt eine Düsenanordnung gemäß einem weiteren Ausführungsbeispiel der Erfindung. Komponenten, welche denjenigen von Fig. 1-7 entsprechend, sind mit den gleichen Bezugszeichen bezeichnet. Die in Fig. 8 dargestellte Düsenanordnung entspricht derjenigen, welche anhand von Fig. 7 beschrieben wurde, wobei jedoch die Düsen jeweils eine zusätzliche Düsenöffnung 22 aufweisen, die dazu ausgestaltet ist, das Behandlungsflüssigkeit in einer Richtung im Wesentlichen senkrecht zu der Transportebene des Behandlungsgutes 10 abzugeben. Durch die zusätzlichen Düsenöffnungen 22 wird die Strömung der Behandlungsflüssigkeit durch Löcher in dem Behandlungsgut, beispielsweise Durchgangslöcher oder Sacklöcher, verstärkt. Auf diese Weise wird eine effektivere Behandlung des Behandlungsgutes 10 im Bereich der darin ausgebildeten Löcher erreicht.

In Fig. 8 sind die zusätzlichen Düsenöffnungen 22 in der oberen Düse und in der unteren Düse einander gegenüberliegend angeordnet. Diese Konfiguration kann beispielsweise zur Behandlung von Sacklöchern von Vorteil sein. Alternativ ist es jedoch auch möglich, die zusätzlichen Düsenöffnungen 22 gegeneinander versetzt anzuordnen, was insbesondere dann von Vorteil ist, wenn eine kontinuierliche Strömung durch Durchgangslöcher des Behandlungsgutes 10 hindurch erreicht werden soll.

Bei der in Fig. 8 dargestellten Düsenanordnung wird die Behandlungsflüssigkeit der zusätzlichen Düsenöffnung 22 über den Flüssigkeitskanal 6 zugeführt, welcher auch der Zuführung der Behandlungsflüssigkeit zu der Düsenöffnung 8 dient. Alternativ ist es möglich, eine separate Zuführung für die Behandlungsflüssigkeit zu der zusätzlichen Düsenöffnung 22 vorzusehen. Hierzu kann der Flüssigkeitskanal 6 z. B. durch eine hier nicht dargestellte Trennwand in zwei separate Kanäle aufgeteilt sein. Weiterhin können zusätzlich Mittel vorgesehen sein, um den Fluss der Behandlungsflüssigkeit durch die zusätzlichen Düsenöffnungen 22 unabhängig von dem Fluss der Behandlungsflüssigkeit durch die Düsenöffnung 8 einzustellen oder zu regeln. Bei einer separaten Zuführung der Behandlungsflüssigkeit zu der zusätzlichen Düsenöffnung 22 kann insbesondere auch eine separate Fördereinrichtung oder Förderpumpe vorgesehen sein.

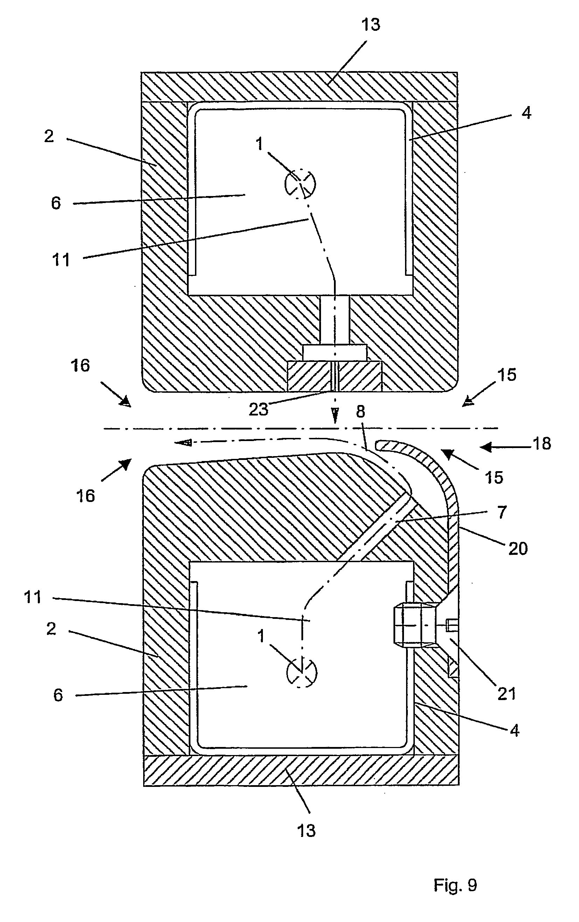

Die in Fig. 8 dargestellte Düsenanordnung weist eine symmetrische Konfiguration auf, mit Düsen oberhalb und unterhalb der Transportebene des Behandlungsgutes 10, wobei diese Düsen spiegelbildlich bezüglich der Transportebene ausgestaltet sind. Wie bereits erwähnt, ist es jedoch nicht zwingend erforderlich, die Düsenanordnung symmetrisch bezüglich der Transportebene auszugestalten. Dies ist beispielsweise der Fall bei dem Ausführungsbeispiel, welches in Fig. 9 dargestellt ist.

Fig. 9 zeigt eine Düsenanordnung, welche aus zwei Düsen besteht, die beidseitig bezüglich der Transportebene des Behandlungsgutes 10 angeordnet sind und unterschiedliche Konfigurationen aufweisen. Komponenten, welche denjenigen von Fig. 1-8 entsprechen, sind wiederum mit den gleichen Bezugszeichen bezeichnet. Die Düse, welche unterhalb der Transportebene angeordnet ist entspricht in ihrer Konfiguration derjenigen, welche in Fig. 7 dargestellt ist. Oberhalb der Transportebene des Behandlungsgutes 10 ist jedoch eine Düse mit abweichender Konfiguration angeordnet. Diese unterscheidet sich von der unterhalb der Transportebene angeordneten Düse insbesondere dadurch, dass sie nur mit einer Düsenöffnung 23 ausgestattet ist, welche die Behandlungsflüssigkeit im Wesentlichen senkrecht zu der Transportebene des Behandlungsgutes 10 abgibt. Dadurch entsteht auf der Seite der Transportebene mit der in etwa senkrecht austretenden Behandlungsflüssigkeit ein Überdruck während auf der anderen Seite ein Unterdruck erzeugt wird. Besonders bei dünnem Behandlungsgut können an der Seite der Transportebene mit Unterdruck zusätzliche Führungselemente oder Stützräder angebracht sein, die in den Figuren nicht dargestellt sind. Der Transport des Behandlungsgutes 10 wird somit in wirkungsvoller Weise unterstützt, während die Düse, welche oberhalb der Transportebene angeordnet ist hinsichtlich der Ausgestaltung ihrer Düsenöffnung 23 flexibel ist und auf spezielle Erfordernisse bei der Behandlung der ihr zugewandten Oberfläche des Behandlungsgutes 10 zugeschnitten sein kann. Insgesamt besteht somit eine hohe Flexibilität bezüglich der Ausgestaltung der erfindungsgemäßen Düsenanordnung.

Zusätzlich ist es möglich, den Einlaufbereich oder den Auslaufbereich der in Fig. 1-9 dargestellten Düsenanordnungen mit Leitelementen zu versehen, welche einerseits dazu dienen, Turbulenzen in der Behandlungsflüssigkeit zu verringern oder zu vermeiden und andererseits auch eine Führungsfunktion für das Behandlungsgut 10 bereitstellen können. Die Leitelemente können beispielsweise in Form von Stegen oder Erhebungen auf der dem Behandlungsgut 10 zugewandten Oberfläche des Gehäuses der Düse ausgestaltet sein. Diese Stege können parallel zu der Transportrichtung 18 ausgerichtet sein, jedoch auch von dieser abweichen, um eine geeignete Führung der Strömung der Behandlungsflüssigkeit zu gewährleisten. Insbesondere in dem Auslaufbereich 16, wo sich der Behandlungskanal typischerweise weitet, kann es von Vorteil sein, die Leitelemente derart auszugestalten, dass diese einen Transportkanal definieren, dessen Querschnitt geringer ist als derjenige des Behandlungskanals. Demnach ist die Bewegung des Behandlungsgutes auf einen vergleichsweise kleinen Bereich senkrecht zu der Transportebene eingeschränkt, während für die Strömung der Behandlungsflüssigkeit zwischen Leitelementen zusätzlicher Raum zur Verfügung steht. Durch die Bereitstellung der Leitelemente kann insbesondere in dem Auslaufbereich 16 der Düsenanordnung eine verbesserte Führung des Behandlungsgutes 10 erreicht werden. Die Leitelemente können auch Räder oder Rollen umfassen.

Es ist weiterhin möglich, die Leitelemente mit Rollen oder Rädern zu kombinieren, wobei die Leitelemente kammartig ausgestaltet sein können und Räder zwischen den Stegen der kammartigen Struktur angeordnet sind. Weiterhin ist es auch möglich, dass Räder oder eine mit Vertiefungen versehene Rolle am Ende einer solchen kammartigen Struktur zwischen deren Stege hineinragen. Diese Maßnahmen sind geeignet, um die Führung des Behandlungsgutes 10 in dem Einlaufbereich 15 und speziell dem Auslaufbereich 16 zu verbessern. Dies ist insbesondere von Vorteil, wenn es sich bei dem Behandlungsgut 10 um ein dünnes folienartiges Material handelt, welches leicht aus seiner Transportebene abgelenkt wird.

Die anhand der Fig. 1-9 beschriebener Düsenanordnungen betreffen in allen Fällen eine Abgabe der Behandlungsflüssigkeit von der Düsenanordnung auf das Behandlungsgut 10. Die Düsenanordnung funktioniert jedoch auch in ähnlicher Weise für ein Absaugen der Behandlungsflüssigkeit vom Behandlungsgut 10 in die Düsenanordnung hinein, wenn hierzu die Transportrichtung des Behandlungsgutes 10 bzw. die Anordnung der Düsen umgekehrt wird. Dies kann insbesondere von Vorteil sein, wenn während der Behandlung Abbauprodukte entstehen oder Feststoffe abgetragen werden. Mit dem Absaugen der Behandlungsflüssigkeit in die Düsenanordnung werden die Abbauprodukte oder Feststoffe mitgerissen und gelangen so auf dem schnellsten Wege z.B. zu einer Regenerationseinheit oder zu einem Filter, der die Feststoffe entfernt. Eine Beeinträchtigung des Behandlungsergebnisses durch diese Stoffe ist damit nahezu ausgeschlossen.

Auch wenn die vorhergehend beschriebenen Ausführungsbeispiele sich auf Düsen bzw. Düsenanordnungen zur Behandlung des Behandlungsguts mit einer Behandlungsflüssigkeit beziehen, ist die Erfindung nicht hierauf beschränkt. Vielmehr eignet sich die erfindungsgemäße Düsenanordnung auch für gasförmige Behandlungsmedien oder Gemische aus flüssigen und gasförmigen Behandlungsmedien. So kann z.B. zum Trocknen von biegsamem dünnem Behandlungsgut heiße Luft oder zum Befeuchten (als Schutz gegen Fleckenbildung) ein Wasser-Luft-Gemisch als Behandlungsmedium eingesetzt werden. Darüber hinaus ist die erfindungsgemäße Düsenanordnung auch für eine Behandlung mit anderen Gasen, die eine chemische Wirkung auf der Oberfläche des Behandlungsguts hervorrufen, wegen der gleichmäßigen Verteilung des Behandlungsmediums gut geeignet.

Der Transport des Behandlungsmediums kann bei den dargestellten Düsenanordnungen nicht nur horizontal sondern auch vertikal erfolgen. Dann muss, um eine gleichmäßige Anströmung zu erreichen, bei der Strömungsverteilung durch die Verteileröffnungen und die justierbare Düsenschiene auf die geodätischen Druckunterschiede an der vertikal positionierten Düse Rücksicht genommen werden. Ein Einsatz ist somit auch bei traditionellen "Vertikalanlagen" möglich, wo die Platten einzeln oder nebeneinander an Gestellen montiert nacheinander in verschiedene Behandlungstanks gesenkt werden. Hier können besonders der Sogeffekt im Einlaufbereich aber auch die anderen Vorteile der Düse von Nutzen sein.

Im Falle eines gasförmigen Behandlungsmediums ist es vorteilhaft, die Düsenanordnung in einem gasförmigen Medium, z.B. dem gasförmigen Behandlungsmedium, anzuordnen.

Weiterhin ist es selbstverständlich möglich, die zuvor anhand von Fig. 1-9 beschriebenen Düsenanordnungen miteinander zu kombinieren. Insbesondere können entlang des Transportweges des Behandlungsgutes mehrere Düsenanordnungen in Serie angeordnet sein. Diese Düsenanordnungen definieren bevorzugt sich ergänzende Behandlungszonen.

Beispielsweise kann eine Behandlungszone zum einseitigen oder beidseitigen Ansaugen von Schmutzpartikeln in die Düsenöffnungen hinein ausgestaltet sein. Eine weitere Behandlungszone kann zum einseitigen oder beidseitigen Aussaugen von Gas durch strömungsbedingten Unterdruck aus Sacklöchern ausgestaltet sein. Noch eine weitere Behandlungszone kann zum Durchspülen von Durchgangslöchern ausgestaltet sein, indem, wie oben erläutert, auf einer Seite des Behandlungsgutes ein Überdruck und auf der anderen Seite des Behandlungsgutes ein Unterdruck erzeugt wird.

Selbstverständlich können auch mehrere Behandlungszonen in einer Düsenanordnung ausgebildet sein.

Weiterhin ist es bevorzugt, den Fluss des Behandlungsmediums, d. h. die Menge der pro Zeiteinheit einer Düsenöffnung oder der Düsenanordnung zugeführten Behandlungsmediums, und den Druck des Behandlungsmediums in Abhängigkeit von der Beschaffenheit des Behandlungsgutes zu regeln oder einzustellen. Dabei können insbesondere die Stärke des Behandlungsgutes, das Vorhandensein von Sacklöchern oder Durchgangslöchern und der Verschmutzungsgrad berücksichtigt werden.

Dabei ist es auch möglich den Fluss und/oder Druck des Behandlungsmediums mehrerer Düsenreihen innerhalb der Düsenanordnung derart separat zu regeln oder einzustellen, dass ein seitliche Auslenkung des Behandlungsgutes aus der Transportbahn verhindert wird.

### BEZUGSZEICHENLISTE

- 1: Anschlussöffnung
- 2: Gehäuse
- 3, 3a: Einsatz
- 4: Versteifung
- 5: Umlenkkanal
- 6: Flüssigkeitskanal
- 7: Verteileröffnung .
- 8: Düsenöffnung
- 9: Verteileröffnung
- 10: Behandlungsgut
- 11, 11': Flüssigkeitsweg
- 12: Einschubleiste
- 13: Gehäusedeckel
- 14: Dichtring
- 15: Einlaufbereich
- 16: Auslaufbereich
- 17: Winkel
- 18: Transportrichtung
- 19: Flüssigkeitsweg
- 20: Düsenschiene
- 21: Einstellschraube
- 22, 23: zusätzliche Düsenöffnung

## Patentansprüche

1. Düsenanordnung zur Behandlung von Behandlungsgut mit einem Behandlungsmedium, wobei das Behandlungsgut (10) in einem Behandlungskanal in einer Transportebene in einer Transportrichtung (18) von einem Einlaufbereich (15) zu einem Auslaufbereich (16) der Düsenanordnung transportierbar ist,
wobei mindestens eine Düsenöffnung (8) vorgesehen ist, welche derart ausgestaltet ist, dass ein Strom des Behandlungsmediums durch die Düsenöffnung (8) in einem vorgegebenen Winkel schräg bezüglich der Transportebene des Behandlungsgutes (10) verläuft, so dass der Strom des Behandlungsmediums in die Transportrichtung (18) des Behandlungsgutes (10) gelenkt wird,
**dadurch gekennzeichnet,**
**dass** die Düsenanordnung zur Behandlung von folienartigem Behandlungsgut ausgestaltet ist, und
**dass** sich der Behandlungskanal in einem Abschnitt zwischen der mindestens einen Düsenöffnung (8) und dem Auslaufbereich (16) in der Transportrichtung (18) vergrößert oder der Auslaufbereich (16) mit Leitelementen zur verbesserten Führung des folienartigen Behandlungsguts (10) versehen ist oder die mindestens eine Düsenöffnung (8) in Form eines Schlitzes ausgestaltet ist.

2. Düsenanordnung nach Anspruch 1,
**dadurch gekennzeichnet,**
**dass** die mindestens eine Düsenöffnung (8) durch mindestens einen Düsenöffnungskanal gebildet ist, welcher in einem spitzen Winkel (17) bezüglich der Transportebene des Behandlungsgutes (10) verläuft.

3. Düsenanordnung nach Anspruch 2,
**dadurch gekennzeichnet,**
**dass** der Winkel (17) höchstens 80° beträgt.

4. Düsenanordnung nach Anspruch 2 oder 3,
**dadurch gekennzeichnet,**
**dass** die mindestens eine Düsenöffnung (8) zur Abgabe des Behandlungsmediums ausgestaltet ist und dass der Winkel (17) sich entgegen der Transportrichtung (18) des Behandlungsgutes (10) öffnet.

5. Düsenanordnung nach Anspruch 4,
**dadurch gekennzeichnet,**
**dass** die mindestens eine Düsenöffnung (8) in einer im Wesentlichen entlang der Transportebene verlaufenden Gehäusewand derart angeordnet ist, dass ein Abstand der mindestens einen Düsenöffnung (8) zu dem Einlaufbereich (15) kleiner ist als ein Abstand der mindestens einen Düsenöffnung (8) zu dem Auslaufbereich (16).

6. Düsenanordnung nach Anspruch 2 oder 3,
**dadurch gekennzeichnet,**
**dass** die mindestens eine Düsenöffnung (8) zur Aufnahme des Behandlungsmediums ausgestaltet ist und dass der Winkel (17) sich in der Transportrichtung (18) des Behandlungsgutes (10) öffnet.

7. Düsenanordnung nach Anspruch 6,
**dadurch gekennzeichnet,**
**dass** die mindestens eine Düsenöffnung (8) in einer im Wesentlichen entlang der Transportebene verlaufenden Gehäusewand derart angeordnet ist, dass ein Abstand der mindestens einen Düsenöffnung (8) zu dem Auslaufbereich (15) kleiner ist als ein Abstand der mindestens einen Düsenöffnung (8) zu dem Einlaufbereich (16).

8. Düsenanordnung nach einem der vorhergehenden Ansprüche,
**dadurch gekennzeichnet,**
**dass** die Düsenanordnung derart ausgestaltet ist, dass sich ein Abstand einer Gehäusewand der Düsenanordnung zu der Transportebene in einem Abschnitt zwischen dem Einlaufbereich (15) und der mindestens einen Düsenöffnung (8) in der Transportrichtung (18) des Behandlungsgutes (10) verringert, so dass in diesem Abschnitt ein sich in Richtung des Einlaufbereichs (15) keilförmig öffnender Kanal zwischen der Gehäusewand und der Transportebene gebildet ist.

9. Düsenanordnung nach einem der vorhergehenden Ansprüche,
**dadurch gekennzeichnet,**
**dass** die Düsenanordnung derart ausgestaltet ist, dass sich ein Abstand einer Gehäusewand der Düsenanordnung zu der Transportebene in einem Abschnitt zwischen der mindestens einen Düsenöffnung (8) und dem Auslaufbereich in der Transportrichtung (18) des Behandlungsgutes (10) vergrößert, so dass in diesem Abschnitt ein sich in Richtung des Auslaufbereichs (16) keilförmig öffnender Kanal zwischen der Gehäusewand und der Transportebene gebildet ist.

10. Düsenanordnung nach einem der vorhergehenden Ansprüche,
**dadurch gekennzeichnet,**
**dass** sich die mindestens eine Düsenöffnung (8) über eine Breite in einer Richtung senkrecht zu der Transportrichtung (18) entlang der.Transportebene erstreckt.

11. Düsenanordnung nach einem der vorhergehenden Ansprüche,
**dadurch gekennzeichnet,**
**dass** der Schlitz durch eine Gehäusewand der Düsenanordnung und durch eine abnehmbare Leiste (12) gebildet ist.

12. Düsenanordnung nach Anspruch 11,
**dadurch gekennzeichnet,**
**dass** der Schlitz auf mindestens einer Seite durch eine Düsenschiene (20) begrenzt ist, welche justierbar an einer Gehäusewand der Düsenanordnung angebracht ist.

13. Düsenanordnung nach Anspruch 12,
**dadurch gekennzeichnet,**
**dass** die Düsenschiene (20) austauschbar ist, um verschiedene Geometrien der Düsenöffnung auswählen zu können.

14. Düsenanordnung nach Anspruch 12 oder 13,
**dadurch gekennzeichnet,**
**dass** die Düsenschiene (20) eine Vorderkante der Düsenanordnung in dem Einlaufbereich (15) definiert.

15. Düsenanordnung nach Anspruch 10,
**dadurch gekennzeichnet,**
**dass** die mindestens eine Düsenöffnung (8) mehrere Öffnungen umfasst, welche voneinander beabstandet entlang der Richtung senkrecht zu der Transportrichtung (18) und parallel zu der Transportebene angeordnet sind.

16. Düsenanordnung nach einem der Ansprüche 10 bis 15,
**dadurch gekennzeichnet,**
**dass** die Düsenanordnung einen sich entlang der mindestens einen Düsenöffnung (8) erstreckenden Mediumkanal (6) zum Transport des Behandlungsmediums umfasst, welcher mit der mindestens einen Düsenöffnung (8) durch Verteileröffnungen (7, 9), welche entlang der mindestens einen Düsenöffnung (8) voneinander beabstandet angeordnet sind, verbunden ist.

17. Düsenanordnung nach Anspruch 16,
**dadurch gekennzeichnet,**
**dass** der Mediumkanal (6) derart ausgestaltet ist, dass sich ein Durchtrittsquerschnitt des Mediumkanals (6) mit zunehmendem Abstand von einer zur Zuführung bzw. Ableitung des Behandlungsmediums vorgesehenen Anschlussöffnung (1) verringert.

18. Düsenanordnung nach Anspruch 17,
**dadurch gekennzeichnet,**
**dass** die Düsenanordnung einen in dem Mediumkanal (6) angeordneten Einsatz (3, 3a) umfasst, dessen Verdrängungsvolumen sich mit zunehmendem Abstand von der Anschlussöffnung (1) vergrößert.

19. Düsenanordnung nach einem der Ansprüche 16 bis 18,
**dadurch gekennzeichnet,**
**dass** die mindestens eine Düsenöffnung (8) durch mindestens einen Düsenöffnungskanal gebildet ist, welcher in einem spitzen Winkel (17) bezüglich der Transportebene des Behandlungsgutes (10) verläuft, und
**dass** die Verteileröffnungen (7) durch Verteilerkanäle gebildet sind, welche in einem Winkel bezüglich der Transportebene des Behandlungsgutes (10) angeordnet sind, der größer ist als der Winkel (17) der Düsenöffnungskanäle bezüglich der Transportebene.

20. Düsenanordnung nach einem der Ansprüche 16 bis 19,
**dadurch gekennzeichnet,**
**dass** die Verteileröffnungen (9) in der Transportrichtung (18) des Behandlungsgutes (10) versetzt gegenüber der mindestens einen Düsenöffnung (8) angeordnet sind.

21. Düsenanordnung nach einem der vorhergehenden Ansprüche,
**dadurch gekennzeichnet,**
**dass** die Düsenanordnung mindestens eine weitere Düsenöffnung (8) umfasst, welche auf einer der mindestens einen Düsenöffnung (8) entgegengesetzt liegenden Seite der Transportebene des Behandlungsgutes (10) angeordnet ist.

22. Düsenanordnung nach Anspruch 21,
**dadurch gekennzeichnet,**
**dass** die Düsenanordnung im Wesentlichen spiegelsymmetrisch bezüglich der Transportebene des Behandlungsgutes (10) ausgestaltet ist.

23. Düsenanordnung nach einem der vorhergehenden Ansprüche,
**dadurch gekennzeichnet,**
**dass** die Düsenanordnung zusätzliche Düsenöffnungen (22, 23) umfasst, welche dazu ausgestaltet sind, das Behandlungsmedium im Wesentlichen senkrecht zu der Transportebene des Behandlungsgutes (10) abzugeben.

24. Düsenanordnung nach einem der vorhergehenden Ansprüche,
**dadurch gekennzeichnet,**
**dass** die Düsenanordnung zur Verwendung in einer Vorrichtung zum nasschemischen Behandeln von Leiterplatten oder Leiterfolien als Behandlungsgut (10) ausgestaltet ist.

25. Düsenanordnung nach einem der vorhergehenden Ansprüche,
**dadurch gekennzeichnet,**
**dass** der Behandlungskanal eine derartige Form aufweist, dass in einem definierten Bereich des Behandlungskanals ein Unterdruck auftritt.

26. Düsenanordnung nach einem der vorhergehenden Ansprüche,
**dadurch gekennzeichnet,**
**dass** die Düsenanordnung derart ausgestaltet ist, dass am Einlaufbereich (15) eine Sogwirkung in die Transportrichtung (18) auftritt.

27. Düsenanordnung nach einem der vorhergehenden Ansprüche,
**dadurch gekennzeichnet,**
**dass** der Behandlungskanal zwischen einer Wand eines Gehäuses (2), in welcher die mindestens eine Düsenöffnung (8) vorgesehen ist, und dem Behandlungsgut (10) ausgebildet ist.

28. Düsenanordnung nach einem der vorhergehenden Ansprüche,
**dadurch gekennzeichnet,**
**dass** eine Vorderkante der Düsenanordnung im Einlaufbereich (15) angeschrägt oder abgerundet ist.

29. Düsenanordnung nach einem der vorhergehenden Ansprüche,
**dadurch gekennzeichnet,**
**dass** der Behandlungskanal derart ausgestaltet ist, dass in einem definierten Bereich des Behandlungskanals ein Unterdruck erzeugt wird.

30. Vorrichtung zum nasschemischen Behandeln von Leiterplatten oder Leiterfolien
**gekennzeichnet durch**
eine Düsenanordnung nach einem der vorhergehenden Ansprüche.

31. Verfahren zur Behandlung von Behandlungsgut mit einem Behandlungsmedium,
wobei das Behandlungsgut (10) in einem Behandlungskanal in einer Transportebene in einer Transportrichtung (18) von einem Einlaufbereich (15) zu einem Auslaufbereich (16) einer Düsenanordnung transportiert wird, und
wobei ein Strom des Behandlungsmediums, welches durch mindestens eine Düsenöffnung (8) der Düsenanordnung abgegeben bzw. aufgenommen wird, in die Transportrichtung (18) des Behandlungsgutes (10) gelenkt wird,
**dadurch gekennzeichnet,**
**dass** das Behandlungsgut ein folienartiges Behandlungsgut ist, und
**dass** sich der Behandlungskanal in einem Abschnitt zwischen der mindestens einen Düsenöffnung (8) und dem Auslaufbereich (16) in der Transportrichtung (18) vergrößert oder der Auslaufbereich (16) mit Leitelementen zur verbesserten Führung des folienartigen Behandlungsguts (10) versehen ist oder die mindestens eine Düsenöffnung (8) in Form eines Schlitzes ausgestaltet ist.

32. Verfahren nach Anspruch 31,
**dadurch gekennzeichnet,**
**dass** das Behandlungsmedium in einem vorgegebenen spitzen Winkel von 1-30° bezüglich der Transportebene des Behandlungsgutes (10) abgegeben bzw. aufgenommen wird.

33. Verfahren nach Anspruch 32,
**dadurch gekennzeichnet,**
**dass** der Winkel (17) höchstens 80° beträgt.

34. Verfahren nach einem der Ansprüche 31-33,
**dadurch gekennzeichnet,**
**dass** das Verfahren umfasst:
- Anpassen der Formgebung der Düsenanordnung, um in mindestens einem definierten Bereich eines Behandlungskanals der Düsenanordnung gezielt einen Unterdruck zu erzeugen.

35. Verfahren nach Anspruch 34,
**dadurch gekennzeichnet,**
**dass** der Unterdruck in dem Einlaufbereich (15) der Düsenanordnung erzeugt wird, um Behandlungsmedium aus der Umgebung des Einlaufbereichs (15) anzusaugen.

36. Verfahren nach einem der Ansprüche 31-35,
**dadurch gekennzeichnet,**
**dass** das Verfahren umfasst:
- Anpassen der Formgebung der Düsenanordnung, um die Strömungsgeschwindigkeit des Behandlungsmediums einzustellen.

37. Verfahren nach einem der Ansprüche 31-36,
**dadurch gekennzeichnet,**
**dass** das Verfahren umfasst:
- Anpassen der Formgebung der Düsenanordnung und der Position der Düsenöffnung (8) und mindestens einer zusätzlichen Düsenöffnung (22; 23) derart, dass in bestimmtem Bereichen der Düsenanordnung auf einer Seite des Behandlungsgutes ein Unterdruck und auf der gegenüberliegenden Seite ein Überdruck erzeugt wird.

38. Verfahren nach einem der Ansprüche 31-37,
**dadurch gekennzeichnet,**
**dass** das Verfahren umfasst:
- Regeln des Flusses des Behandlungsmediums, welches der Düsenanordnung zugeführt wird.

39. Verfahren nach einem der Ansprüche 31-38,
**dadurch gekennzeichnet,**
**dass** das Verfahren umfasst:
- Regeln des Druckes des Behandlungsmediums, welches der Düsenanordnung zugeführt wird.

40. Verfahren nach einem der Ansprüche 31-39,
**dadurch gekennzeichnet,**
**dass** das Verfahren umfasst:
- Erzeugen einer Sogwirkung am Einlaufbereich (15) in die Transportrichtung (18).

41. Verfahren nach einem der Ansprüche 31-40,
**dadurch gekennzeichnet,**
**dass** der Behandlungskanal zwischen einer Wand eines Gehäuses (2), in welcher die Düsenöffnung (8) vorgesehen ist, und dem Behandlungsgut ausgebildet ist.

42. Verfahren nach einem der Ansprüche 31-41,
**dadurch gekennzeichnet,**
**dass** eine Vorderkante der Düsenanordnung im Einlaufbereich (15) angeschrägt oder abgerundet ist.

43. Verfahren nach einem der Ansprüche 31-42,
**dadurch gekennzeichnet,**
**dass** die Düsenanordnung nach einem der Ansprüche 1-30 ausgestaltet ist.

## Claims

1. Nozzle arrangement for the treatment of treated material with a treatment medium, wherein the treated material (10) is capable of being conveyed within a treatment channel in a conveying plane in a conveying direction (18) from an inlet area (15) to an outlet area (16) of the nozzle arrangement,
at least one nozzle aperture (8) being provided, which is designed in such a way that a flow of the treatment medium through the nozzle aperture (8) runs at a predetermined angle obliquely in relation to the conveying plane of the treated material (10), so that the flow of the treated medium is deflected into the conveying direction (18) of the treated material (10),
**characterised in that**
the nozzle arrangement is designed for the treatment of a film-type treated material, and **in that**
the treatment channel enlarges in a section between the at least one nozzle aperture (8) and the outlet area (16) in the conveying direction (18), or the outlet area (16) is provided with guide elements for improved guiding of the film-type treated material (10), or the at least one nozzle aperture (8) is designed in the form of a slot.

2. Nozzle arrangement according to Claim 1,
**characterised in that**
the at least one nozzle aperture (8) is formed by at least one nozzle aperture channel, which extends at an acute angle (17) in relation to the conveying plane of the treated material (10).

3. Nozzle arrangement according to Claim 2,
**characterised in that**
the angle (17) amounts to a maximum of 80°.

4. Nozzle arrangement according to Claim 2 or 3,
**characterised in that**
the at least one nozzle aperture (8) is designed to emit the treatment medium, and that the angle (17) opens against the conveying direction (18) of the treated material (10).

5. Nozzle arrangement according to Claim 4,
**characterised in that**
the at least one nozzle aperture (8) is arranged in a housing wall extending essentially along the conveying plane in such a way that a distance between the at least one nozzle aperture (8) and the inlet area (15) is smaller than a distance between the at least one nozzle aperture (8) and the outlet area (16).

6. Nozzle arrangement according to Claim 2 or 3,
**characterised in that**
the at least one nozzle aperture (8) is designed to receive the treatment medium, and that the angle (17) opens in the conveying direction (18) of the treated material (10).

7. Nozzle arrangement according to Claim 6,
**characterised in that**
the at least one nozzle aperture (8) is arranged in a housing wall extending essentially along the conveying plane, in such a way that a distance between the at least one nozzle aperture (8) and the outlet area (15) is smaller than a distance between the at least one nozzle aperture (6) and the inlet area (16).

8. Nozzle arrangement according to any one of the preceding claims,
**characterised in that**
the nozzle arrangement is designed in such a way that a distance between a housing wall of the nozzle arrangement and the conveying plane decreases in a section between the inlet area (15) and the at least one nozzle aperture (8) in the conveying direction of the treated material (10), so that in this section a channel opening in a wedge shape in the direction of the inlet area (15) is formed between the housing wall and the conveying plane.

9. Nozzle arrangement according to any one of the preceding claims,
**characterised in that**
the nozzle arrangement is designed in such a way that a distance between a housing wall of the nozzle arrangement and the conveying plane increases in a section between the at least one nozzle aperture (8) and the outlet area in the conveying direction (18) of the treated material (10), so that in this section a channel is formed which opens in a wedge shape in the direction of the outlet area (16), between the housing wall and the conveying plane.

10. Nozzle arrangement according to any one of the preceding claims,
**characterised in that**
the at least one nozzle aperture (8) extends over a width in a direction perpendicular to the conveying direction (18) along the conveying plane.

11. Nozzle arrangement according to any one of the preceding claims,
**characterised in that**
the slot is formed by a housing wall of the nozzle arrangement and by a removable strip (12).

12. Nozzle arrangement according to Claim 11,
**characterised in that**
the slot is delimited on at least one side by a nozzle rail (20), which is located in an adjustable manner at a housing wall of the nozzle arrangement.

13. Nozzle arrangement according to Claim 12,
**characterised in that**
the nozzle rail (20) is exchangeable, in order to be able to select different geometries of the nozzle aperture.

14. Nozzle arrangement according to Claim 12 or 13,
**characterised in that**
the nozzle rail (20) defines a front edge of the nozzle arrangement in the inlet area (15).

15. Nozzle arrangement according to Claim 10,
**characterised in that**
the at least one nozzle aperture (8) comprises several apertures, which are spaced from one another along the direction perpendicular to the conveying direction (18) and parallel to the conveying plane.

16. Nozzle arrangement according to any one of Claims 10 to 15,
**characterised in that**
the nozzle arrangement comprises a medium channel (6) extending along at least one nozzle aperture (8) for transport of the treatment medium, which is connected to the at least one nozzle aperture (8) by distribution apertures (7, 9) which are spaced from one another along the at least one nozzle aperture (8).

17. Nozzle arrangement according to Claim 16,
**characterised in that**
the medium channel (6) is designed in such a way that a passage cross-section of the medium channel (6) decreases as the distance from a connection aperture (1) provided for the delivery or removal respectively of the treatment medium increases.

18. Nozzle arrangement according to Claim 17,
**characterised in that**
the nozzle arrangement comprises an insertion element (3,3a) arranged in the medium channel (6), the displacement volume of which increases as the distance interval from the connection aperture (1) increases.

19. Nozzle arrangement according to any one of Claims 16 to 18,
**characterised in that**
the at least one nozzle aperture (8) is formed by at least one nozzle aperture channel, which extends at an acute angle (17) in relation to the conveying plane of the treatment material (10), and
that the distribution apertures (7) are formed by distribution channels, which are arranged at an angle in relation to the conveying plane of the treated material (10) which is greater than the angle (17) of the nozzle aperture channels in relation to the conveying plane.

20. Nozzle arrangement according to any one of Claims 16 to 19,
**characterised in that**
**that** the distribution apertures (9) are offset in relation to the at least one nozzle aperture (8) in the conveying direction (18) of the treated material (10).

21. Nozzle arrangement according to any one of the preceding claims,
**characterised in that**
the nozzle arrangement comprises at least one further nozzle aperture (8), which is arranged on a side of the conveying plane of the treated material (10) opposite to the at least one nozzle aperture (8).

22. Nozzle arrangement according to Claim 21,
**characterised in that**
the nozzle arrangement is designed essentially mirror-symmetrical in relation to the conveying plane of the treated material (10).

23. Nozzle arrangement according to any one of the preceding claims,
**characterised in that**
the nozzle arrangement comprises additional nozzle apertures (22, 23), which are designed in such a way as to emit the treatment medium essentially perpendicular to the conveying plane of the treated material (10).

24. Nozzle arrangement according to any one of the preceding claims,
**characterised in that**
the nozzle arrangement is designed for use in a device for the wet-chemical treatment of printed circuit boards or printed circuit films as treated material (10).

25. Nozzle arrangement according to any one of the preceding claims,
**characterised in that**
the treatment channel has such a shape that a negative pressure arises in a defined section of the treatment channel.

26. Nozzle arrangement according to any one of the preceding claims,
**characterised in that**
the nozzle arrangement is designed in such a way that a suction effect in the conveying direction (18) arises at the inlet area (15).

27. Nozzle arrangement according to any one of the preceding claims,
**characterised in that**
the treatment channel is formed between a wall of a housing (2), in which the at least one nozzle aperture (8) is provided, and the treated material (10).

28. Nozzle arrangement according to any one of the preceding claims,
**characterised in that**
a front edge of the nozzle arrangement is bevelled or rounded in the inlet area (15).

29. Nozzle arrangement according to any one of the preceding claims,
**characterised in that**
the treatment channel is designed in such a way that a negative pressure is created in a defined section of the treatment channel.

30. Device for the wet-chemical treatment of printed circuit boards or printed circuit films
**characterised by**
a nozzle arrangement according to any one of the preceding claims.

31. Method for the treatment of treated material with a treatment medium, wherein the treated material (10) is conveyed within a treatment channel in a conveying plane in a conveying direction (18) from an inlet area (15) to an outlet area (16) of a nozzle arrangement, and
wherein a flow of the treatment medium, which is emitted or received by a nozzle aperture (8) of the nozzle arrangement, is deflected into the conveying direction (18) of the treated material (10),
**characterised in that**
the treated material is a film-type treated material, and **in that**
the treatment channel enlarges in a section between the at least one nozzle aperture (8) and the outlet area (16) in the conveying direction (18) or the outlet area (16) is provided with guide elements for improved guiding of the film-type treated material (10), or the at least one nozzle aperture (8) is designed in the form of a slot.

32. Method according to Claim 31,
**characterised in that**
the treatment medium is emitted or received at a predetermined acute angle of 1-30° in relation to the conveying plane of the treated material (10).

33. Method according to Claim 32,
**characterised in that**
the angle (17) amounts to a maximum of 80°.

34. Method according to any one of Claims 31-33,
**characterised in that**
the method comprises:
- adaptation of the shaping of the nozzle arrangement in order to specifically create a negative pressure in at least one defined area of a treatment channel of the nozzle arrangement.

35. Method according to Claim 34,
**characterised in that**
the negative pressure is created in the inlet area (15) of the nozzle arrangement, in order for treatment medium to be drawn in from the surroundings of the inlet area (15).

36. Method according to any one of Claims 31-35,
**characterised in that**
the method comprises:
- adaptation of the shaping of the nozzle arrangement in order to adjust the flow rate of the treatment medium.

37. Method according to any one of Claims 31-36,
**characterised in that**
the method comprises:
- adaptation of the shaping of the nozzle arrangement and of the positions of the nozzle aperture (8) and at least one additional nozzle aperture (22; 23) in such a way that, in specific areas of the nozzle arrangement, a negative pressure is created on one side of the treated material and a positive pressure is created on the opposite side.

38. Method according to any one of Claims 31-37,
**characterised in that**
the method comprises:
- controlling the flow of the treatment medium which is supplied to the nozzle arrangement.

39. Method according to any one of Claims 31-38,
**characterised in that**
the method comprises:
- controlling the pressure of the treatment medium which is supplied to the nozzle arrangement.

40. Method according to any one of Claims 31-39,
**characterised in that**
the method comprises:
- creating a suction effect in the conveying direction (18) at the inlet area (15).

41. Method according to any one of Claims 31-40,
**characterised in that**
the treatment channel is formed between a wall of a housing (2), in which the nozzle aperture (8) is provided, and the treated material.

42. Method according to any one of Claims 31-41,
**characterised in that**
a front edge of the nozzle arrangement is bevelled or rounded in the inlet area (15).

43. Method according to any one of Claims 31-42,
**characterised in that**
the nozzle arrangement is designed in accordance with one of Claims 1-30.

## Revendications

1. Dispositif injecteur pour le traitement d'un produit à traiter au moyen d'un milieu de traitement, le produit à traiter (10) étant transportable dans un canal de traitement sur un plan de transport dans une direction de transport (18), d'une zone d'admission (15) à une zone de sortie (16) du dispositif injecteur,
où est prévu au moins un orifice de buse (8) réalisé de telle manière qu'un flux du milieu de traitement traverse l'orifice de buse (8) suivant un angle défini, obliquement par rapport au plan de transport du produit (10), pour que le flux du milieu de traitement soit amené dans la direction de transport (18) du produit (10),
**caractérisé en ce que**
le dispositif injecteur est exécuté pour le traitement d'un produit en forme de feuille, et
**en ce que** le canal de traitement est agrandi dans une portion entre le ou les orifices de buse (8) et la zone de sortie (16) dans la direction de transport (18), ou la zone de sortie (16) pourvue d'éléments de guidage pour une meilleure conduite du produit en forme de feuille (10), ou le ou les orifices de buse (8) réalisés sous forme de fente.

2. Dispositif injecteur selon la revendication 1,
**caractérisé en ce que**
le ou les orifices de buse (8) sont formés par au moins un canal d'orifice de buse s'étendant suivant un angle aigu (17) par rapport au plan de transport du produit (10).

3. Dispositif injecteur selon la revendication 2,
**caractérisé en ce que**
l'angle (17) est au maximum de 80°.

4. Dispositif injecteur selon la revendication 2 ou la revendication 3,
**caractérisé en ce que**
le ou les orifices de buse (8) sont réalisés pour l'injection du milieu de traitement, et **en ce que** l'angle (17) est ouvert dans le sens opposé à la direction de transport (18) du produit (10).

5. Dispositif injecteur selon la revendication 4,
**caractérisé en ce que**
le ou les orifices de buse (8) sont disposés dans une paroi de carter s'étendant sensiblement le long du plan de transport, de telle manière qu'un intervalle entre le ou les orifices de buse (8) et la zone d'admission (15) soit inférieur à un intervalle entre le ou les orifices de buse (8) et la zone de sortie (16).

6. Dispositif injecteur selon la revendication 2 ou la revendication 3,
**caractérisé en ce que**
le ou les orifices de buse (8) sont réalisés pour la réception du milieu de traitement, et **en ce que** l'angle (17) est ouvert dans la direction de transport (18) du produit (10).

7. Dispositif injecteur selon la revendication 6,
**caractérisé en ce que**
le ou les orifices de buse (8) sont disposés dans une paroi de carter s'étendant sensiblement le long du plan de transport, de telle manière qu'un intervalle entre le ou les orifices de buse (8) et la zone de sortie (16) soit inférieur à un intervalle entre le ou les orifices de buse (8) et la zone d'admission (15).

8. Dispositif injecteur selon l'une des revendications précédentes,
**caractérisé en ce que**
le dispositif injecteur est exécuté de telle manière qu'un intervalle entre une paroi du carter du dispositif injecteur et le plan de transport soit rétréci dans une portion entre la zone d'admission (15) et le ou les orifices de buse (8) dans la direction de transport (18) du produit (10), de manière à former dans cette portion un canal s'ouvrant coniquement vers la zone d'admission (15) entre la paroi du carter et le plan de transport.

9. Dispositif injecteur selon l'une des revendications précédentes,
**caractérisé en ce que**
le dispositif injecteur est exécuté de telle manière qu'un intervalle entre une paroi du carter du dispositif injecteur et le plan de transport soit agrandi dans une portion entre le ou les orifices de buse (8) et la zone de sortie dans la direction de transport (18) du produit (10), de manière à former dans cette portion un canal s'ouvrant coniquement vers la zone de sortie (16) entre la paroi du carter et le plan de transport.

10. Dispositif injecteur selon l'une des revendications précédentes,
**caractérisé en ce que**
le ou les orifices de buse (8) s'étendent sur une largeur dans une direction perpendiculaire à la direction de transport (18) le long du plan de transport.

11. Dispositif injecteur selon l'une des revendications précédentes,
**caractérisé en ce que**
la fente est formée par une paroi du carter du dispositif injecteur et par une baguette amovible (12).

12. Dispositif injecteur selon la revendication 11,
**caractérisé en ce que**
la fente est limitée sur au moins un côté par un rail de buse (20) monté et ajustable sur une paroi du carter du dispositif injecteur.

13. Dispositif injecteur selon la revendication 12,
**caractérisé en ce que**
le rail de buse (20) est remplaçable pour permettre de sélectionner des géométries différentes pour l'orifice de buse.

14. Dispositif injecteur selon la revendication 12 ou la revendication 13,
**caractérisé en ce que**
le rail de buse (20) définit un bord avant du dispositif de buse dans la zone d'admission (15).

15. Dispositif injecteur selon la revendication 10,
**caractérisé en ce que**
le ou les orifices de buse (8) comportent plusieurs orifices disposés à intervalle l'un de l'autre le long de la direction perpendiculaire à la direction de transport (18) et parallèle au plan de transport.

16. Dispositif injecteur selon l'une des revendications 10 à 15,
**caractérisé en ce que**
le dispositif injecteur comprend un canal de milieu (6) s'étendant le long du ou des orifices de buse (8) pour le transport du milieu de traitement, lequel est relié à l'orifice ou aux orifices de buse (8) par des orifices de distribution (7, 9) disposés à intervalle l'un de l'autre le long de l'orifice ou des orifices de buse (8).

17. Dispositif injecteur selon la revendication 16,
**caractérisé en ce que**
le canal de milieu (6) est réalisé de telle manière qu'une section de passage du canal de milieu (6) se rétrécit à mesure qu'augmente la distance à un orifice de raccordement (1) prévu pour l'amenée ou la dérivation du milieu de traitement.

18. Dispositif injecteur selon la revendication 17,
**caractérisé en ce que**
le dispositif injecteur comprend une garniture (3, 3a) disposée dans le canal de milieu (6), dont la capacité de déplacement s'accroît à mesure qu'augmente la distance à l'orifice de raccordement (1).

19. Dispositif injecteur selon l'une des revendications 16 à 18,
**caractérisé en ce que**
le ou les orifices de buse (8) sont formés par au moins un canal d'orifice de buse s'étendant suivant un angle aigu (17) par rapport au plan de transport du produit (10), et
**en ce que** les orifices de distribution (7) sont formés par des canaux de distribution disposés suivant un angle par rapport au plan de transport du produit (10) qui est supérieur à l'angle (17) des canaux d'orifice de buse par rapport au plan de transport.

20. Dispositif injecteur selon l'une des revendications 16 à 19,
**caractérisé en ce que**
les orifices de distribution (9) dans la direction de transport (18) du produit (10) sont décalés par rapport à l'orifice ou aux orifices de buse (8).

21. Dispositif injecteur selon l'une des revendications précédentes,
**caractérisé en ce que**
le dispositif injecteur comprend au moins un autre orifice de buse (8) disposé sur un côté du plan de transport du produit (10) opposé à l'orifice ou aux orifices de buse (8).

22. Dispositif injecteur selon la revendication 21,
**caractérisé en ce que**
le dispositif injecteur est essentiellement réalisé en symétrie spéculaire par rapport au plan de transport du produit (10).

23. Dispositif injecteur selon l'une des revendications précédentes,
**caractérisé en ce que**
le dispositif injecteur comporte des orifices de buse additionnels (22, 23) exécutés de manière à injecter le milieu de traitement sensiblement perpendiculairement au plan de transport du produit (10).

24. Dispositif injecteur selon l'une des revendications précédentes,
**caractérisé en ce que**
le dispositif injecteur est réalisé pour être utilisé dans un dispositif pour le traitement chimique par voie humide de plaquettes ou de feuilles de circuit imprimé en tant que produit à traiter (10).

25. Dispositif injecteur selon l'une des revendications précédentes,
**caractérisé en ce que**
le canal de traitement présente une forme telle qu'une dépression est formée dans une zone définie du canal de traitement.

26. Dispositif injecteur selon l'une des revendications précédentes,
**caractérisé en ce que**
le dispositif injecteur est réalisé de manière à générer un effet d'aspiration sur la zone d'admission (15) dans la direction de transport (18).

27. Dispositif injecteur selon l'une des revendications précédentes,
**caractérisé en ce que**
le canal de traitement est réalisé entre une paroi d'un carter (2), où sont prévus le ou les orifices de buse (8), et le produit à traiter (10).

28. Dispositif injecteur selon l'une des revendications précédentes,
**caractérisé en ce qu'**
un bord avant du dispositif injecteur est biseauté ou arrondi dans la zone d'admission (15).

29. Dispositif injecteur selon l'une des revendications précédentes,
**caractérisé en ce que**
le canal de traitement est réalisé de manière à générer une dépression dans une zone définie du canal de traitement.

30. Dispositif pour le traitement chimique par voie humide de plaquettes ou de feuilles de circuit imprimé,
**caractérisé par**
un dispositif injecteur selon l'une des revendications précédentes.

31. Procédé pour le traitement d'un produit au moyen d'un milieu de traitement,
le produit à traiter (10) étant transportable dans un canal de traitement sur un plan de transport dans une direction de transport (18), d'une zone d'admission (15) à une zone de sortie (16) d'un dispositif injecteur, et
où un flux du milieu de traitement injecté ou capté par traversée d'au moins un orifice de buse (8) du dispositif injecteur est amené dans la direction de transport (18) du produit (10),
**caractérisé en ce que**
le produit à traiter est un produit en forme de feuille,
et **en ce que** le canal de traitement est agrandi dans une portion entre le ou les orifices de buse (8) et la zone de sortie (16) dans la direction de transport (18), ou la zone de sortie (16) pourvue d'éléments de guidage pour une meilleure conduite du produit en forme de feuille (10), ou le ou les orifices de buse (8) réalisés sous forme de fente.

32. Procédé selon la revendication 31,
**caractérisé en ce que**
le milieu de traitement est injecté ou capté suivant un angle aigu défini compris entre 1 et 30° par rapport au plan de transport du produit (10).

33. Procédé selon la revendication 32,
**caractérisé en ce que**
l'angle (17) est au maximum de 80°.

34. Procédé selon l'une des revendications 31 à 33,
**caractérisé en ce que**
le procédé comprend :
- l'adaptation de forme du dispositif injecteur pour générer une dépression de manière ciblée dans au moins une zone définie d'un canal de traitement du dispositif injecteur.

35. Procédé selon la revendication 34,
**caractérisé en ce que**
la dépression est générée dans la zone d'admission (15) du dispositif injecteur pour aspirer le milieu de traitement de l'environnement de la zone d'admission (15).

36. Procédé selon l'une des revendications 31 à 35,
**caractérisé en ce que**
le procédé comprend :
- l'adaptation de forme du dispositif injecteur pour régler la vitesse d'écoulement du milieu de traitement.

37. Procédé selon l'une des revendications 31 à 36,
**caractérisé en ce que**
le procédé comprend :
- l'adaptation de forme du dispositif injecteur et de position de l'orifice de bise (8) et d'au moins un orifice de buse additionnel (22, 23), de manière à générer une dépression sur un côté du produit dans certaines zones du dispositif injecteur, et une surpression sur le côté opposé.

38. Procédé selon l'une des revendications 31 à 37,
**caractérisé en ce que**
le procédé comprend :
- la régulation du flux du milieu de traitement amené au dispositif injecteur.

39. Procédé selon l'une des revendications 31 à 38,
**caractérisé en ce que**
le procédé comprend :
- la régulation de pression du milieu de traitement amené au dispositif injecteur.

40. Procédé selon l'une des revendications 31 à 39,
**caractérisé en ce que**
le procédé comprend :
- la génération d'un effet d'aspiration sur la zone d'admission (15) dans la direction de transport (18).

41. Procédé selon l'une des revendications 31 à 40,
**caractérisé en ce que**
le canal de traitement est réalisé entre une paroi d'un carter (2), où est prévu l'orifice de buse (8), et le produit.

42. Procédé selon l'une des revendications 31 à 41,
**caractérisé en ce qu'**
un bord avant du dispositif injecteur est biseauté ou arrondi dans la zone d'admission (15).

43. Procédé selon l'une des revendications 31 à 42,
**caractérisé en ce que**
le dispositif injecteur est réalisé selon l'une des revendications 1 à 30.
